# EUROPEAN PATENT APPLICATION

(11) **EP 4 141 939 A1**
(43) Date of publication of application: **01.03.2023**
(21) Application number: 21792391.1
(22) Date of filing: 29.01.2021
(51) Int. Cl.: H01L 27/146, G01C 3/08, H01L 21/3205, H01L 21/768, H01L 23/522, H01L 27/144, H01L 31/107, H04N 5/369

(54) **LIGHT DETECTOR AND ELECTRONIC INSTRUMENT**

(30) Priority: 24.04.2020 JP 2020077267
(71) Applicant: Sony Semiconductor Solutions Corporation, Atsugi-shi, Kanagawa 243-0014 (JP)
(72) Inventor: OTAKE, Yusuke, Atsugi-shi, Kanagawa 243-0014 (JP); WAKANO, Toshifumi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/003353
(87) International publication number: WO 2021/215066

(57) **Abstract**

To improve sensitivity to near-infrared light and suppress deterioration of timing jitter characteristics. A photodetector includes: a pixel region in which a plurality of pixels each having a photoelectric converter is arranged in a matrix, in which the photoelectric converter includes: a first semiconductor portion segmented by a separator; a second semiconductor portion provided on a side of a first face of the first semiconductor portion, the first face being opposite to a second face of the first semiconductor portion, the second semiconductor portion containing germanium; a light absorber with which the second semiconductor portion is provided, the light absorber being configured to absorb light having entered the second semiconductor portion to generate a carrier; and a multiplier with which the first semiconductor portion is provided, the multiplier being configured to avalanche-multiply the carrier generated by the light absorber.

## Description

### TECHNICAL FIELD

The present technology (technology according to the present disclosure) relates to a photodetector and an electronic apparatus, and particularly relates to a technology effective in application to a photodetector and an electronic apparatus including an avalanche photo diode (APD).

### BACKGROUND ART

In recent years, a distance image sensor that measures a distance by a time of flight (ToF) method has attracted attention as a photodetector. The distance pixel sensor includes a pixel array unit with a plurality of pixels arranged in a matrix. In addition, the efficiency of the entire device is determined by the dimension of the pixels and the pixel structure.

Patent Document 1 discloses a pixel including a photoelectric converter including an APD element as a photoelectric conversion element. The photoelectric converter includes a light absorber that absorbs light having entered a semiconductor layer and generates carriers, and a multiplier that avalanche-multiplies the carriers generated by the light absorber.

### CITATION LIST

### PATENT DOCUMENT

Patent Document 1: Japanese Patent Application Laid-Open No. 2018-088488

### SUMMARY OF THE INVENTION

### PROBLEMS TO BE SOLVED BY THE INVENTION

Meanwhile, in order to increase the sensitivity of the photoelectric converter (APD element) to near-infrared light, it is effective to increase the thickness of the semiconductor layer in which an avalanche region is formed. However, an increase in the thickness of the semiconductor layer results in deterioration of the timing jitter characteristics that are important as ToF.

An object of the present technology is to provide a photodetector capable of improving sensitivity to near-infrared light and suppressing deterioration of timing jitter characteristics, and an electronic apparatus including the photodetector.

### SOLUTIONS TO PROBLEMS

A photodetector according to an aspect of the present technology includes:
a pixel region in which a plurality of pixels each having a photoelectric converter is arranged in a matrix, in which the photoelectric converter includes: a first semiconductor portion segmented by a separator;
a second semiconductor portion provided on a side of a first face of the first semiconductor portion, the first face being opposite to a second face of the first semiconductor portion, the second semiconductor portion containing germanium; a light absorber with which the second semiconductor portion is provided, the light absorber being configured to absorb light having entered the second semiconductor portion to generate a carrier; and
a multiplier with which the first semiconductor portion is provided, the multiplier being configured to avalanche-multiply the carrier generated by the light absorber.

An electronic apparatus according to another aspect of the present technology includes: a photodetector including: a pixel region in which a plurality of pixels each having a photoelectric converter is arranged in a matrix, in which the photoelectric converter includes: a first semiconductor portion segmented by a separator; a second semiconductor portion provided on a side of a first face of the first semiconductor portion, the first face being opposite to a second face of the first semiconductor portion, the second semiconductor portion containing germanium; a light absorber with which the second semiconductor portion is provided, the light absorber being configured to absorb light having entered the second semiconductor portion to generate a carrier; and a multiplier with which the first semiconductor portion is provided, the multiplier being configured to avalanche-multiply the carrier generated by the light absorber; and an optical system configured to form an image onto the first face of the first semiconductor portion, with image light from a subject.

### BRIEF DESCRIPTION OF DRAWINGS

Fig. 1 is a chip layout illustrating an exemplary configuration of a distance image sensor according to a first embodiment of the present technology.
Fig. 2 is a block diagram illustrating the exemplary configuration of the distance image sensor according to the first embodiment of the present technology.
Fig. 3 is an equivalent circuit diagram illustrating an exemplary configuration of a pixel.
Fig. 4 is a main-part plan view illustrating the exemplary configuration of the pixel.
Fig. 5 is a main-part sectional view illustrating a sectional structure taken along line II-II in Fig. 4.
Fig. 6 is a main-part enlarged sectional view with part of Fig. 5 enlarged.
Fig. 7 is a main-part sectional view illustrating a sectional structure of a pixel region and a peripheral region.
Fig. 8 is a main-part sectional view illustrating an exemplary configuration of a pixel of a distance image sensor according to a second embodiment of the present technology.
Fig. 9 is a main-part sectional view illustrating an exemplary configuration of a pixel of a distance image sensor according to a third embodiment of the present technology.
Fig. 10 is a main-part sectional view illustrating an exemplary configuration of a pixel of a distance image sensor according to a fourth embodiment of the present technology.
Fig. 11 is a main-part sectional view of illustrating an exemplary configuration of a pixel of a distance image sensor according to a fifth embodiment of the present technology.
Fig. 12 is a main-part sectional view illustrating an exemplary configuration of a pixel of a distance image sensor according to a sixth embodiment of the present technology.
Fig. 13A is a main-part sectional view illustrating a first modification of the distance image sensor according to the sixth embodiment of the present technology.
Fig. 13B is a main-part sectional view illustrating a second modification of the distance image sensor according to the sixth embodiment of the present technology.
Fig. 14 is a main-part sectional view illustrating a third modification of the distance image sensor according to the sixth embodiment of the present technology.
Fig. 15 is a main-part sectional view illustrating an exemplary configuration of a pixel of a distance image sensor according to a seventh embodiment of the present technology.
Fig. 16 is a main-part sectional view illustrating an exemplary configuration of a pixel of a distance image sensor according to an eighth embodiment of the present technology.
Fig. 17 is a main-part sectional view illustrating an exemplary configuration of a pixel of a distance image sensor according to a ninth embodiment of the present technology.
Fig. 18 is a main-part sectional view illustrating an exemplary configuration of a pixel of a distance image sensor according to a tenth embodiment of the present technology.
Fig. 19 is a main-part sectional view illustrating an exemplary configuration of a pixel of a distance image sensor according to an eleventh embodiment of the present technology.
Fig. 20A is a main-part sectional view illustrating an exemplary configuration of a pixel of a distance image sensor according to a twelfth embodiment of the present technology.
Fig. 20B is a main-part enlarged sectional view with part of Fig. 20A enlarged.
Fig. 21 is a main-part sectional view illustrating an exemplary configuration of a pixel of a distance image sensor according to a thirteenth embodiment of the present technology.
Fig. 22 is a main-part sectional view illustrating an exemplary configuration of a pixel of a distance image sensor according to a fourteenth embodiment of the present technology.
Fig. 23 is a main-part sectional view illustrating an exemplary configuration of a pixel of a distance image sensor according to a fifteenth embodiment of the present technology.
Fig. 24 is a main-part sectional view illustrating an exemplary configuration of a pixel of a distance image sensor according to a sixteenth embodiment of the present technology.
Fig. 25 is a main-part sectional view illustrating an exemplary configuration of a pixel of a distance image sensor according to a seventeenth embodiment of the present technology.
Fig. 26 is a main-part sectional view illustrating an exemplary configuration of a pixel of a distance image sensor according to an eighteenth embodiment of the present technology.
Fig. 27 is a main-part sectional view illustrating an exemplary configuration of a pixel of a distance image sensor according to a nineteenth embodiment of the present technology.
Fig. 28 is a block diagram illustrating an exemplary configuration of a distance image apparatus with a sensor chip of the present technology.

### MODE FOR CARRYING OUT THE INVENTION

Hereinafter, embodiments of the present technology will be described in detail with reference to the drawings.

Note that, in all the drawings for describing the embodiments of the present technology, components having the same functions are denoted with the same reference signs, and repeated description thereof will be omitted.

In addition, each drawing is schematic and thus may be different from an actual one. Further, the following embodiments illustrate a device and a method for embodying the technical idea of the present invention, and do not specify the configurations as follows. That is, various modifications can be made to the technical idea of the present invention within the technical scope described in the claims.

Furthermore, in the following embodiments, in three directions orthogonal to each other in a space, a first direction and a second direction orthogonal to each other in the same plane are defined as an X direction and a Y direction, respectively, and a third direction orthogonal to each of the first direction and the second direction is defined as a Z direction. Still furthermore, In the following embodiments, the thickness direction of a semiconductor layer is described as the Z direction.

### [First Embodiment]

In Embodiment 1, an example in which the present technology is applied to a distance image sensor that is a back-irradiation type complementary metal oxide semiconductor (CMOS) image sensor as a photodetector will be described.

### <<Overall Configuration of Distance Image Sensor>>

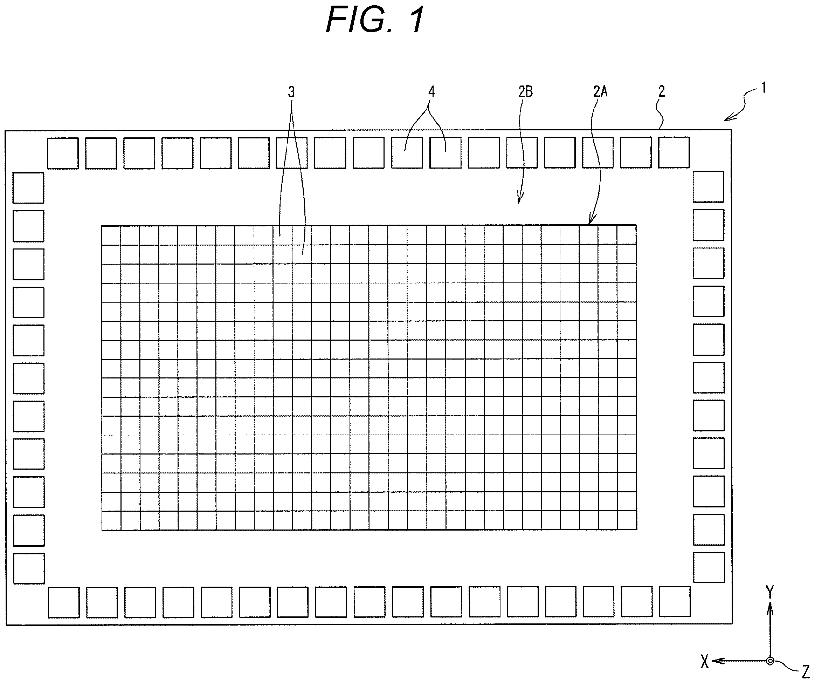

As illustrated in Fig. 1, a distance image sensor 1 according to the first embodiment of the present technology mainly includes a sensor chip 2 rectangular in two-dimensional planar shape when viewed in a plan view. That is, the distance image sensor 1 is mounted on the sensor chip 2. The sensor chip 2 includes, in a two-dimensional plane, a rectangular pixel region 2A disposed in a central portion and a peripheral region 2B disposed outside the pixel region 2A so as to surround the pixel region 2A.

The pixel region 2A is a light-receiving face that receives light condensed by an optical system (not illustrated). Further, in the pixel region 2A, a plurality of pixels 3 is arranged in a matrix in a two-dimensional plane including the X direction and the Y direction.

A plurality of electrode pads 4 is disposed in the peripheral region 2B. Each of the plurality of electrode pads 4 is arranged, for example, along four sides in the two-dimensional plane of the sensor chip 2. Each of the plurality of electrode pads 4 is an input/output terminal for use in electric connection of the sensor chip 2 to an external device (not illustrated).

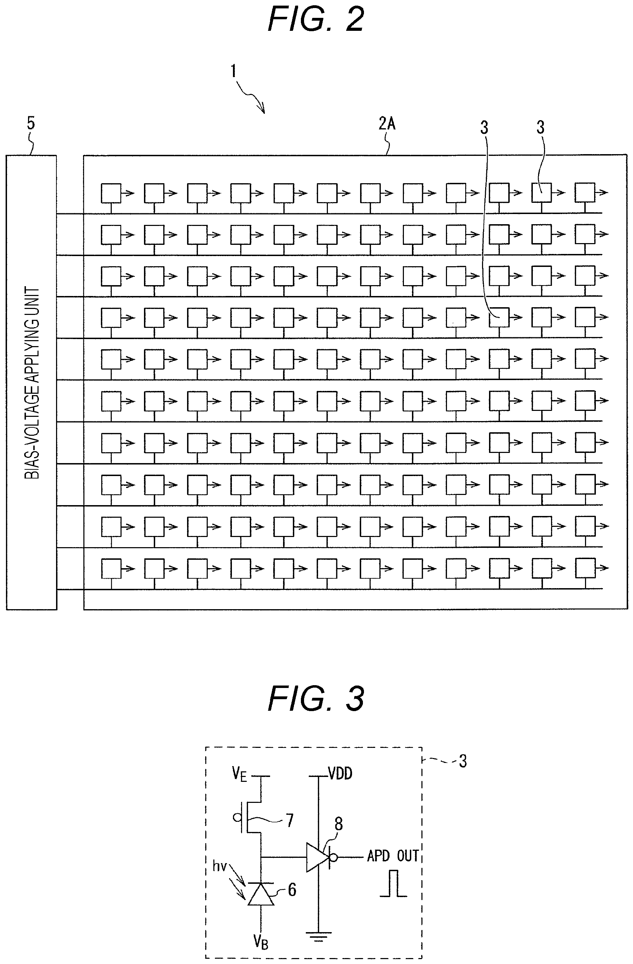

As illustrated in Fig. 2, the sensor chip 2 includes a bias-voltage applying unit 5 together with the pixel region 2A. The bias-voltage applying unit 5 applies a bias voltage to each of the plurality of pixels 3 arranged in the pixel region 2A. As illustrated in Fig. 3, each pixel 3 of the plurality of pixels 3 includes, for example, an avalanche photodiode (APD) element 6 as a photoelectric conversion element; a quenching resistive element 7 including, for example, a p-type metal oxide semiconductor field effect transistor (MOSFET); and an inverter 8 including, for example, a complementary MOSFET (conplementary MOS).

The APD element 6 has an anode connected to the bias-voltage applying unit 5 (see Fig. 2) and a cathode connected to its source terminal of the quenching resistive element 7. A bias voltage V_{B} is applied from the bias-voltage applying unit 5 to the anode of the APD element 6. The APD element 6 is a photoelectric conversion element capable of forming an avalanche multiplication region (depletion layer) due to application of a large negative voltage to the cathode and causing the electrons generated due to incidence of one font to be avalanche multiplied.

The quenching resistive element 7 is connected in series with the APD element 6. Its source terminal of the quenching resistive element 7 is connected to the cathode of the APD element 6, and its drain terminal thereof is connected to a power supply (not illustrated). An excitation voltage V_{E} is applied from the power supply to the drain terminal of the quenching resistive element 7. When the voltage due to the electrons avalanche-multiplied by the APD element 6 reaches the negative voltage V_{BD}, the quenching resistive element 7 emits the electrons multiplied by the APD element 6 and performs quenting to return the voltage to the initial voltage.

As illustrated in Fig. 3, the inverter 8 has an input terminal connected to the cathode of the APD element 6 and the source terminal of the quenching resistive element 7, and an output terminal connected to an arithmetic processing unit (not illustrated) at the subsequent stage. The inverter 8 outputs a light reception signal on the basis of the electrons multiplied by the APD element 6. More specifically, the inverter 8 shapes the voltage generated due to the electrons multiplied by the APD element 6. Then, the inverter 8 outputs, to the arithmetic processing unit, a light reception signal (APD OUT) having a pulse waveform generated at the arrival time of one font as a start point in Fig. 3. For example, on the basis of the timing at which the pulse indicating the arrival time of one font in each light reception signal is generated, the arithmetic processing unit performs arithmetic processing of obtaining the distance to a subject to obtain the distance for each pixel 3. Then, on the basis of these distances, a distance image in which the distances to the subject detected by the plurality of pixels 3 are planarly arranged is generated.

### <Configuration of Sensor Chip>

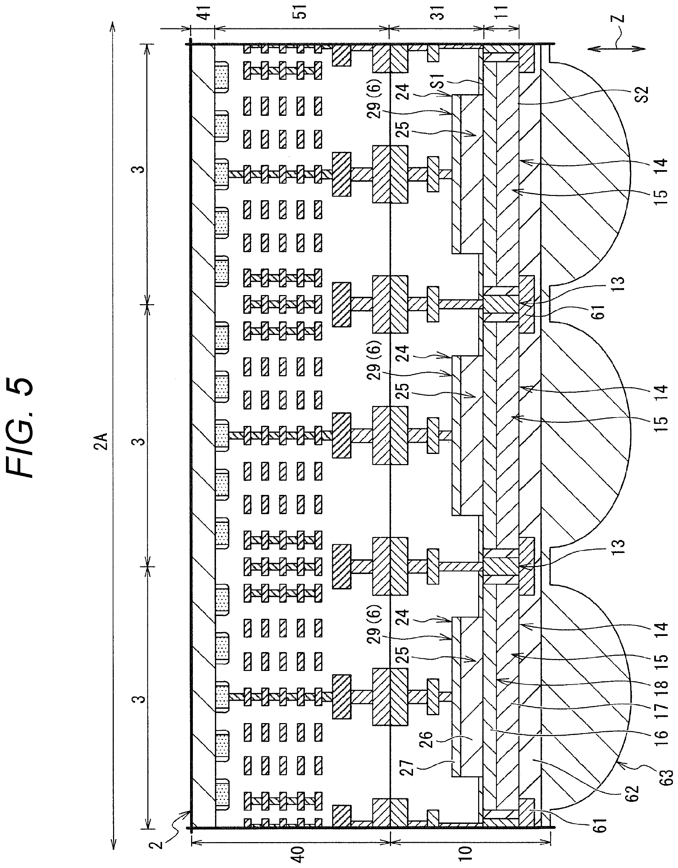

As illustrated in Fig. 5, the sensor chip 2 includes a first semiconductor base (sensor-side semiconductor base) 10 and a second semiconductor base (logic-side semiconductor base) 40 layered facing each other. The above pixel region 2A is provided on the first semiconductor base 10. On the second semiconductor base 40, provided are the bias-voltage applying unit 5; the electrode pad 4; a reading circuit that outputs each pixel signal based on the charges output from the corresponding pixel 3 of the pixel region 2A; and a logic circuit including, for example, a vertical drive circuit, a column-signal processing circuit, an output circuit, and a horizontal drive circuit.

As illustrated in Fig. 5, the first semiconductor base 10 includes a semiconductor layer 11 and a multi-level wiring layer (sensor-side multi-level wiring layer) 31. The first semiconductor base 10 has a first face S1 and a second face S2 opposite to each other in the thickness direction (Z direction) thereof, and the multi-level wiring layer 31 is disposed on the side of the first face S1. In addition, on the side of the second face S2 of the semiconductor layer 11, the first semiconductor base 10 further includes a light blocking film 61, a planarization film 62, and a microlens layer 63 sequentially layered in order from the side closer to the second face S2.

The second semiconductor base 40 includes a semiconductor substrate 41 having a first face and a second face, and a multi-level wiring layer (logic-side multi-level wiring layer) 51 disposed on the side of the first face of the semiconductor substrate 41. Further, the first semiconductor base 10 and the second semiconductor base 40 are layered such that the multi-level wiring layer 31 and the multi-level wiring layer 51 faces each other, and the multi-level wiring layer 31 and the multi-level wiring layer 51 are connected electrically and mechanically.

### <Configuration of First Semiconductor Base>

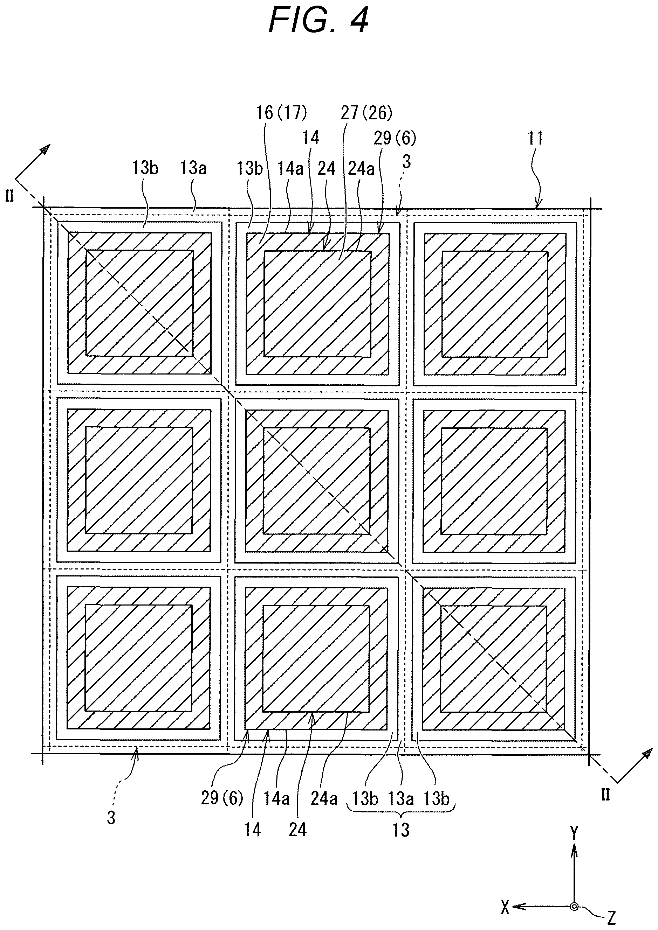

As illustrated in Figs. 4 to 6, the semiconductor layer 11 of the first semiconductor base 10 includes a separator 13 and a first semiconductor portion 14 segmented by the separator 13. Further, a second semiconductor portion 24 is provided in superimposition on the first semiconductor portion 14 on the side of the first face of the first face and the second face opposite to each other of the first semiconductor portion 14. Here, the first face of the first semiconductor portion 14 is the same face as the first face S1 of the semiconductor layer 11, and the second face of the first semiconductor portion 14 is the same face as the second face S2 of the semiconductor layer 11. Thus, the first face and the second face of the first semiconductor portion 14 may also be referred to as a first face S1 and a second face S2, respectively. Further, the first face S1 may also be referred to as a main face, and the second face S2 may also be referred to as a light incident face or a back face.

The semiconductor layer 11 has a dotted pattern of repeated arrangement of first semiconductor portions 14 in both of the X direction and the Y direction through the separator 13. The semiconductor layer 11 can be defined as a semiconductor interspersed layer having a dotted pattern of repeated arrangement of a plurality of first semiconductor portions 14 interspersed through the separator 13 in the two-dimensional plane including the X direction and the Y direction. Further, the semiconductor layer 11 can also be defined as a semiconductor interspersed layer having a dotted pattern of repeated arrangement of first semiconductor portions 14 segmented by the separator 13 interspersed in both of the X direction and the Y direction. Furthermore, the semiconductor layer 11 can also be defined as a semiconductor coupling layer in which the adjacent first semiconductor portions 14 are coupled through the separator 13. Although not limited thereto, for example, such a semiconductor layer 11 as described above can be formed by forming, on a semiconductor substrate, a separator extending from the side of the first face to the side of the second face of the first and second faces opposite to each other of the semiconductor substrate, and then cutting until the separator is exposed on the side of the second face of the semiconductor substrate to reduce the thickness of the semiconductor substrate. A first semiconductor portion 14 is arranged corresponding to each pixel 3. The separator 13 extends from the side of the first face S1 to the side of the second face S2 of the first semiconductor portion 14.

As illustrated in Figs. 4 to 6, the first semiconductor portions 14 of the plurality of first semiconductor portions 14 are arranged one-to-one corresponding to the pixels 3 of the plurality of pixels 3 in the pixel region 2A. Further, the first semiconductor portions 14 of the plurality of first semiconductor portions 14 each have a planar pattern in which a planar shape when viewed in a plan view toward the first face S1 of the semiconductor layer 11 is square.

As illustrated in Figs. 4 to 6, the second semiconductor portion 24 is provided in each of the plurality of first semiconductor portions 14. The second semiconductor portions 24 each have a planar pattern in which a planar shape when viewed in a plan view toward the first face S1 is square (refer to Fig. 4). In addition, such a second semiconductor portion 24 as described above is smaller in outer size toward the first face S1 than the first semiconductor portion 14 in plan view. That is, the second semiconductor portion 24 has a contour 24a located inside a contour 14a of the first semiconductor portion 14 (outside the separator 13) in plan view.

As illustrated in Fig. 4, the separator 13 corresponding to a single pixel 3 has an annularly planar pattern in which a planar pattern in plan view is rectangular. And, although not illustrated in detail in Fig. 4, the separator 13 corresponding to the pixel region 2A has a composite planar pattern having a latticed planar pattern in an annularly planar pattern in which a planar pattern in plan view is rectangular. The separator 13 electrically and optically separates a first semiconductor portion 14 and a first semiconductor portion 14 adjacent to each other.

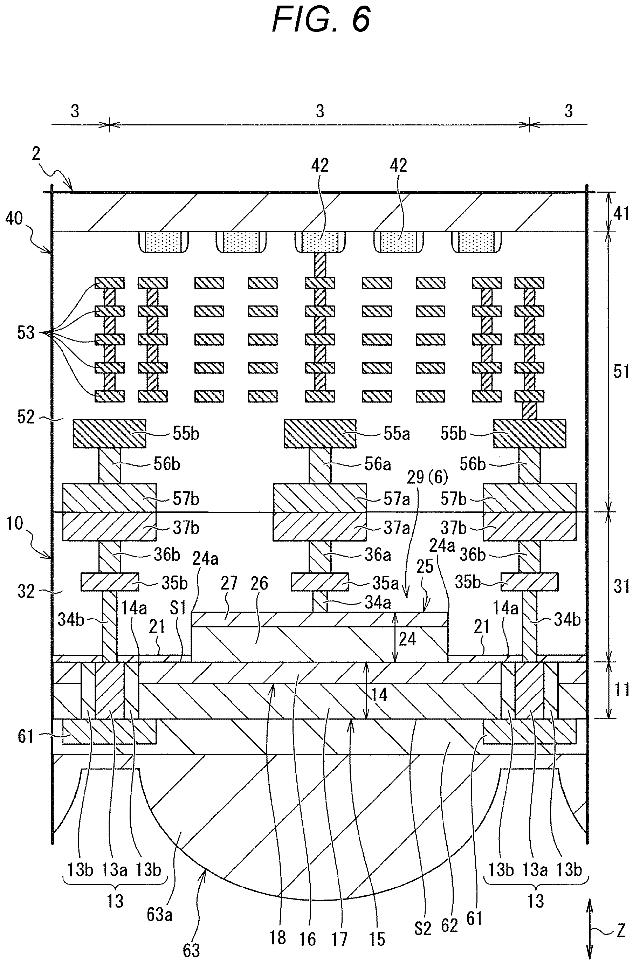

As illustrated in Fig. 6, the separator 13 includes a separation conductor 13a extending in the thickness direction (Z direction) of the first semiconductor portion 14 and a separation insulator 13b covering a side face on either side of the separation conductor 13a. That is, the separator 13 has a three-layered structure with both sides of the separation conductor 13a are sandwiched between separation insulators 13b in the direction orthogonal to the thickness direction of the first semiconductor portion 14. Further, the separator 13 extends from the first face S1 to the second face S2 of the first semiconductor portion 14. The separation conductor 13a includes a metal film excellent in light reflectivity and conductivity, for example, a tungsten (W) film. The separation insulator 13b as described above includes an insulating film excellent in insulation, for example, a silicon oxide (SiO₂) film.

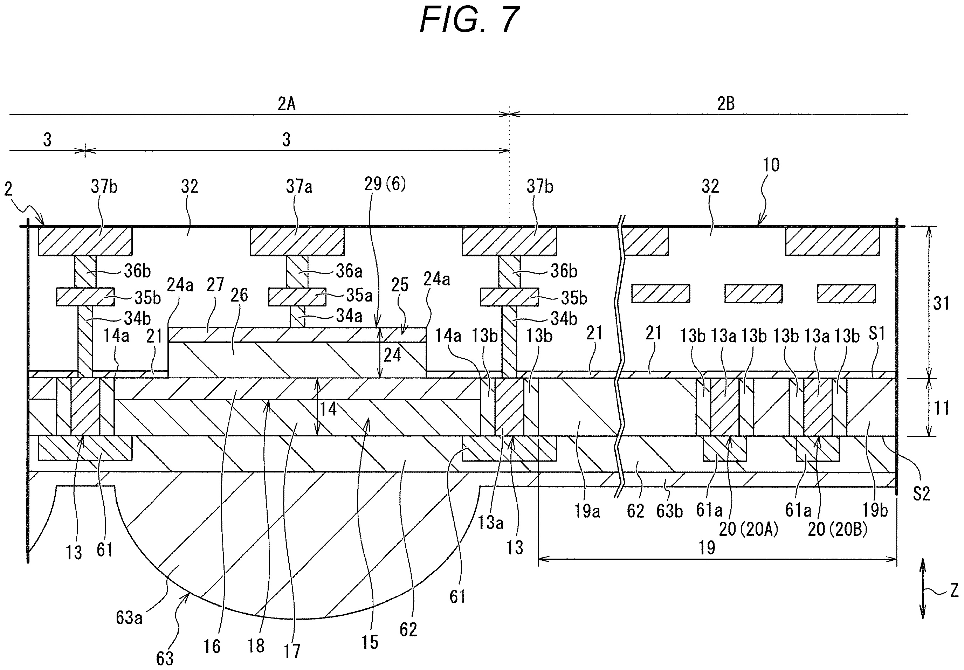

As illustrated in Fig. 7, the light blocking film 61 is disposed in the pixel region 2A in plan view. Although not illustrated in detail, the light blocking film 61 has a latticed planar pattern in which a photoelectric converter 29 to be described later has an opening on the side of the its light-receiving face in a planar pattern in plan view such that light from a predetermined pixel 3 does not leak into the adjacent pixel 3. The light blocking film 61 is not limited thereto, but includes, for example, a composite film in which a titanium (Ti) film and a tungsten (W) film are layered in order from the side closer to the semiconductor layer 11. The Ti film and the W film have both light blocking properties and conductivity. Although described later, the light blocking film 61 also has a function as a relay electrode.

### (Configuration of Photoelectric Converter)

As illustrated in Fig. 6, each pixel 3 of the plurality of pixels 3 includes a photoelectric converter 29 including the above APD element 6. The photoelectric converter 29 includes a multiplier 15 with which the first semiconductor portion 14 is provided and a light absorber 25 with which the second semiconductor portion 24 is provided.

The first semiconductor portion 14 includes, for example, single crystal silicon (Si). The second semiconductor portion 24 includes a material containing germanium (Ge) and narrower in band gap than the first semiconductor portion 14. For example, in the first embodiment, the second semiconductor portion 24 includes a composite layer in which an intrinsic semiconductor (i-SiGe) layer 26 including a compound of silicon (Si) and germanium (Ge) and a p-type extrinsic semiconductor (p-SiGe) layer 27 including a compound of Si and Ge and having the same conductivity type as the p-type first semiconductor region 16 of the first semiconductor portion 14 are disposed in order from the side of the first semiconductor portion 14.

The light absorber 25 mainly includes the second semiconductor portion 24, and has a photoelectric conversion function of absorbing light having entered from the side of the light incident face as the second face S2 of the first semiconductor portion 14 to generate charges (electrons). Then, the charges generated resulting from the photoelectric conversion by the light absorber 25 flow into the multiplier 15 due to potential gradient.

The multiplier 15 avalanche-multiplies the charges having flown from the light absorber 25. The multiplier 15 includes the p-type first semiconductor region 16 provided on the side of the first face S1 of the first semiconductor portion 14, and an n-type second semiconductor region 17 provided at a position deeper than the position of the p-type first semiconductor region 16 with respect to the side of the first face S1 of the first semiconductor portion 14, and the n-type second semiconductor region 17 and the bottom of the p-type first semiconductor region 16 forms a pn junction 18. Then, an avalanche multiplication region is formed in the pn junction 18. The avalanche multiplication region is a high electric field region (depletion layer) formed in the pn junction 18 due to a large negative voltage applied to the n-type second semiconductor region 17, and multiplies electrons (e-) generated in one font incident on the photoelectric converter 29 (APD element 6).

In the second semiconductor portion 24, the intrinsic semiconductor layer 26 is covalently bonded with the p-type first semiconductor region 16 of the first semiconductor portion 14. The extrinsic semiconductor layer 27 on the intrinsic semiconductor layer 26 preferably has the same conductivity type as the first semiconductor region 16 with which the intrinsic semiconductor layer 26 is covalently bonded.

The intrinsic semiconductor layer 26 of the second semiconductor portion 24 includes an epitaxial layer selectively formed on the first face S1 of the first semiconductor portion 14 by, for example, an epitaxial growth method. The p-type extrinsic semiconductor layer 27 includes a p-type semiconductor region formed by implanting boron (B) ions, boron difluoride (BF₂) ions, or the like as p-type impurities into an upper portion of the intrinsic semiconductor layer 26, for example. The p-type extrinsic semiconductor layer 27 may include a p-type epitaxial layer formed on the intrinsic semiconductor layer 26 while further adding impurities by an epitaxial growth method.

Here, a single element semiconductor of Ge or a compound semiconductor containing Ge is narrower in band gap and higher in sensitivity to near-infrared light than a single element semiconductor of Si. Therefore, the photoelectric converter 29 included in the light absorber 25 with which the second semiconductor portion 24 including a compound of SiGe is provided and the multiplier 15 with which the first semiconductor portion 14 including Si is provided can photoelectrically convert near-infrared light in an efficient manner.

Further, a single element semiconductor of Ge or a compound semiconductor containing Ge is high in affinity with a single element semiconductor of Si. Thus, the second semiconductor portion 24 including the compound of SiGe and the first semiconductor portion 14 including Si can be covalently bonded with each other in an easy manner.

As illustrated in Fig. 6, a selection insulating film 21 for selectively forming the second semiconductor portion 24 is provided on the side of the first face S1 of the first semiconductor portion 14. In the first embodiment, the selection insulating film 21 is a surface-type insulating film covering the respective surfaces of the separator 13 and the first semiconductor portion 14. As the selection insulating film 21, used can be an insulating film such as a silicon oxide (SiO₂) film, a silicon nitride (SiN) film, or an aluminum oxide (Al₂O₃) film that can be deposited on the side of the first face S1 of the first semiconductor portion 14 by, for example, a chemical vapor deposition (CVD) method.

The selection insulating film 21 is selectively provided outside the second semiconductor portion 24 except for the first semiconductor portion 14 immediately below the second semiconductor portion 24. The selection insulating film 21 has an opening exposing part of the first semiconductor portion 14, and the second semiconductor portion 24 is selectively formed through the opening by, for example, an epitaxial growth method. That is, the second semiconductor portion 24 is an epitaxial layer selectively formed, by an epitaxial growth method, through the opening provided in the selection insulating film 21 on the first semiconductor portion 14. Therefore, the second semiconductor portion 24 is formed in covalently bonding with the first semiconductor portion 14 on the side of the first face S1 of the first semiconductor portion 14 due to self-alignment to the selection insulating film 21.

As illustrated in Figs. 4 and 6, each of the p-type first semiconductor region 16 and the n-type second semiconductor region 17 of the first semiconductor portion 14 is in contact with the separation insulator 13b of the separator 13 over the outer periphery of the first semiconductor portion 14. Further, the n-type second semiconductor region 17 is electrically connected to the separation conductor 13a through the light blocking film 61 provided on the side of the second face S2 of the first semiconductor portion 14.

As illustrated in Fig. 6, the light blocking film 61 overlaps the separator 13 in the Z direction. The light blocking film 61 wider in width than the separator 13, and also overlaps the peripheral region of each of two first semiconductor portions 14 adjacent to each other through the separator 13. The light blocking film 61 has an annularly planar pattern in which a planar pattern when viewed in a plan view toward the second face S2 is rectangular. The light blocking film 61 is electrically and mechanically connected to the separation conductor 13a of the separator 13 over the entire circumference of the annularly planar pattern, and is electrically and mechanically connected in contact with each of the respective n-type second semiconductor regions 17 of two first semiconductor portions 14 adjacent to each other through the separator 13.

The light blocking film 61 relays electrical connection between the n-type second semiconductor region 17 of the first semiconductor portion 14 and the separation conductor 13a of the separator 13. Then, as described above, the light blocking film 61 suppresses light having entered a predetermined pixel 3 from leaking into the adjacent pixel 3. Thus, the light blocking film 61 has both a function as a relay electrode and a light blocking function.

Note that although not illustrated, in the n-type second semiconductor region 17, a contact region including a semiconductor region higher in impurity concentration than the n-type second semiconductor region 17 is provided at a portion to which the relay electrode 61 is connected, for the purpose of reducing ohmic contact resistance with the light blocking film 61.

### (Configuration of Multi-Level Wiring Layer)

As illustrated in Fig. 6, the multi-level wiring layer 31 of the first semiconductor base 10 has a two-layer wiring structure in which wiring layers are layered in, for example, two stages with an interlayer insulating film 32 interposed therebetween. A first metal wired line 35a and a second metal wired line 35b are provided in a wiring layer as the first layer counted from the side of the semiconductor layer 11. Metal pads 37a and 37b are provided in a wiring layer as the second layer counted from the side of the semiconductor layer 11. Further, contact electrodes 34a and 34b are embedded in the interlayer insulating film 32 between the first wiring layer and the semiconductor layer 11. Furthermore, contact electrodes 36a and 36b are embedded in the interlayer insulating film 32 between the first wiring layer and the second wiring layer.

The contact electrode 34a electrically connects the p-type extrinsic semiconductor layer 27 of the second semiconductor portion 24 and the first metal wired line 35a. The contact electrode 34b electrically connects the separation conductor 13a of the separator 13 and the second metal wired line 35b. The contact electrode 36a electrically connects the first metal wired line 35a and the metal pad 37a. The contact electrode 36b electrically connects the second metal wired line 35b and the metal pad 37b. The metal pad 37a and the metal pad 37b are, respectively, electrically and mechanically connected to a metal pad 57a and a metal pad 57b provided in the multi-level wiring layer 51 of the second semiconductor base 40 to be described later by metal-to-metal joint.

### <Configuration of Second Semiconductor Base>

As illustrated in Fig. 6, on the semiconductor substrate 41 of the second semiconductor base 40, for example, provided is a plurality of MOSFETs as field effect transistors included in circuits such as the bias-voltage applying unit 5, the reading circuit, and the logic circuit. Figs. 5 and 6 illustrate respective gate electrodes 42 of the plurality of MOSFETs. As the semiconductor substrate 41, for example, a semiconductor substrate including single crystal silicon is used.

### (Configuration of Multi-Level Wiring Layer)

As illustrated in Fig. 6, the multi-level wiring layer 51 of the second semiconductor base 40 has a seven-layer wiring structure in which wiring layers are layered in, for example, seven stages through an interlayer insulating film 52. A wired line 53 is provided in each of wiring layers as the first to fifth wiring layer counted from the side of the semiconductor substrate 41. The respective wired lines 53 of the first to fifth wiring layers are electrically connected mutually through contact electrodes embedded in the interlayer insulating film 52. In addition, the wired line 53 of the first wiring layer is electrically connected to a MOSFET of the semiconductor substrate through a contact electrode embedded in the interlayer insulating film 52. Fig. 6 illustrates, as an example, a configuration in which the wired line 53 of the first wiring layer is electrically connected to the gate electrode 42 of a MOSFET through the contact electrode.

Electrode pads 55a and 55b are provided in a wiring layer as the sixth wiring layer counted from the side of the semiconductor substrate 41. Metal pads 57a and 57b are provided in a wiring layer as the seventh wiring layer counted from the side of the semiconductor substrate 41. Further, contact electrodes 56a and 56b are provided in the interlayer insulating film 52 between the sixth wiring layer and the seventh wiring layer. The contact electrode 56a electrically connects the electrode pad 55a and the metal pad 57a. The contact electrode 56b electrically connects the electrode pad 55b and the metal pad 57b. The electrode pads 55a and 55b are each electrically connected to the wired line 53 of the lower wiring layer. The metal pad 57a is joined to the metal pad 37a on the side of the first semiconductor base 10, and the metal pad 57b is joined to the metal pad 37b on the side of the first semiconductor base 10.

### (Configuration of Conductive Path)

As illustrated in Fig. 6, in the second semiconductor base 40, the electrode pad 55a is electrically connected to a MOSFET of the semiconductor substrate 41 through the wired line 53 of each wiring layer and the contact electrode of each interlayer insulating film 52, and is electrically connected to the contact electrode 56a and the metal pad 57a. Further, in the first semiconductor base 10, the metal pad 37a is electrically connected to the p-type extrinsic semiconductor layer 27 of the second semiconductor portion 24 through the contact electrode 36a, the first metal wired line 35a, and the contact electrode 34a. Furthermore, the metal pad 57a of the second semiconductor base 40 is electrically and mechanically joined to the metal pad 37a of the first semiconductor base 10.

Therefore, a pixel 3 can supply the bias voltage V_{B} from the bias-voltage applying unit 5 included in the second semiconductor base 40 to the second semiconductor portion 24 (light absorber 25) included in the first semiconductor base 10.

In addition, as illustrated in Fig. 6, in the second semiconductor base 40, the electrode pad 55b is electrically connected to a MOSFETs of the semiconductor substrate 41 through the wired line 53 of each wiring layer and the contact electrode of each interlayer insulating film 52, and is electrically connected to the contact electrode 56b and the metal pad 57b. Further, in the first semiconductor base 10, the metal pad 37a is electrically connected to the n-type second semiconductor region 17 of the first semiconductor portion 14 through the contact electrode 36b, the second metal wired line 35b, the contact electrode 34b, the separation conductor 13a of the separator 13, and the relay electrode 61.

Therefore, in a pixel 3, the source terminal of the quenching resistive element 7 and the input terminal of the inverter 8 included in the second semiconductor base 40 can be electrically connected to the n-type second semiconductor region 17 of the first semiconductor portion 14 included in the first semiconductor base 10, which enables bias adjustment to the n-type second semiconductor region 17 (cathode of the APD element 6).

Further, the separation conductor 13a of the separator 13 is used as a conductive route for electrically connecting the source terminal of the quenching element 7 and the input terminal of the inverter 8 to the n-type second semiconductor region 17 of the first semiconductor portion 14. Therefore, in the pixel 3, the potential of the separation conductor 13a of the separator 13 can be fixed by the bias voltage.

Here, in the second semiconductor portion 24 selectively formed by the epitaxial growth method, the composition is more likely to vary in the peripheral region than in the central region. Therefore, it is preferable to connect the contact electrode 34a to the central region where the composition is easily formed uniformly in the second semiconductor portion 24.

### (Configuration of Peripheral Region)

As illustrated in Fig. 7, in addition to the separator 13 and the first semiconductor portion 14, the semiconductor layer 11 further includes a peripheral semiconductor portion 19 disposed in the peripheral region 2B.

The peripheral semiconductor portion 19 is formed in the same layer as the first semiconductor portion 14, and includes single crystal silicon similar to that of the first semiconductor portion 14. Although not illustrated in detail, the peripheral semiconductor portion 19 has an annularly planar pattern in which a planar pattern in plan view surrounds the pixel region 2A.

The peripheral semiconductor portion 19 includes a first peripheral region 19a adjacent to the pixel region 2A and sharing a potential supplied to the pixel region 2A, and a second peripheral region 19b electrically separated from the first peripheral region 19a outside the first peripheral region 19a. Further, the peripheral semiconductor portion 19 includes a separator 20 that electrically separates the first peripheral region 19a and the second peripheral region 19b. In the first embodiment, although not limited thereto, two separators 20A and 20B are provided.

Although not illustrated in detail, each of the two separators 20A and 20B has an annularly planar pattern in which a planar pattern in plan view extends so as to surround the pixel region 2A. In addition, in the two-dimensional plane including the X direction and the Y direction, each of the two separators 20A and 20B is spaced apart from the separator 13 disposed on the outermost periphery of the pixel region 2A as illustrated in Fig. 7. Moreover, the two separators 20A and 20B are also spaced apart from each other.

The first peripheral region 19a is disposed outside the pixel region 2A so as to surround the pixel region 2A. Further, the second peripheral region 19b is disposed outside the first peripheral region 19a so as to surround the first peripheral region 19a. That is, the first peripheral region 19a and the second peripheral region 19b each have an annular pattern in which a planar pattern in plan view surrounds the pixel region 2A. Here, also in the peripheral semiconductor portion 19, among the first face and the second face opposite to each other in the thickness direction of the semiconductor layer 11, the first face may be referred to as a first face S1 and the second face may be referred to as a second face S2.

The first peripheral region 19a includes, for example, an n-type second semiconductor region. The second peripheral region 19b includes, for example, a p-type semiconductor region. The peripheral semiconductor portion 19 between the two separators 20A and 20B includes for example, a p-type semiconductor region similarly to the second peripheral region 19b.

As illustrated in Fig. 7, each of the two separators 20A and 20B extends from the side of the first face S1 to the side of the second face S2 of the peripheral semiconductor portion 19. In addition, similarly to the separator 13, each of the two separators 20A and 20B includes a separation conductor 13a extending in the thickness direction (Z direction) of the peripheral semiconductor portion 19 and a separation insulator 13b covering a side face on either side of the separation conductor 13a. That is, each of the two separators 20A and 20B also has a three-layer structure in which the both sides of the separation conductor 13a are sandwiched between separation insulators 13b in the direction orthogonal to the thickness direction (Z direction) of the peripheral semiconductor portion 19. The separation conductor 13a and the separation insulator 13b of the two respective separators 20A and 20B are formed in the same process as the separation conductor 13a and the separation insulators 13b, respectively, of the separator 13 described above.

Light blocking films 61a provided on the side of the second face S2 of the peripheral semiconductor portion 19 are electrically and mechanically connected one-to-one to the two separators 20A and 20B. The light blocking films 61a are formed in the same process as the above light blocking films 61. The light blocking films 61a are disposed one-to-one in superimposition on the two separators 20A and 20B when viewed in a plan view.

As illustrated in Fig. 7, the light blocking film 61 located on the outermost periphery of the pixel region 2A is in contact with the n-type second semiconductor region 17 of the first semiconductor portion 14 on the side of the pixel region 2A of the separator 13 and is electrically and mechanically connected to the n-type second semiconductor region 17 of the first semiconductor portion 14 on side of the pixel region 2A of the separator 13, and is electrically and mechanically connected to the first peripheral region 19a of the peripheral semiconductor portion 19 on the side of the peripheral region 2B of the separator 13. That is, a bias voltage supplied as a common potential to each pixel 3 in the pixel region 2A is applied to the first peripheral region 19a of the peripheral semiconductor portion 19 adjacent to the outermost peripheral pixel 3 in the pixel region 2A through the separator 13. In the first embodiment, the contact electrode 34a electrically connected to the p-type extrinsic semiconductor layer 27 of the second semiconductor portion 24 is on side of the anode of the APD element 6, and the contact electrode 34b electrically connected to the n-type second semiconductor region 17 of the first semiconductor portion 14 is on the side of the cathode of the APD element 6. Thus, the first peripheral region 19a of the peripheral semiconductor portion 19 shares a cathode potential supplied as the common potential to the respective photoelectric converters 29 of the pixels 3.

Unlike the above light blocking film 61, the light blocking films 61a are each narrower in width than the separators 20A and 20B. In addition, the light blocking film 61a in superimposition on the separator 20A is electrically separated from the first peripheral region 19a of the peripheral semiconductor portion 19, and the light blocking film 61a in superimposition on the separator 20B is electrically separated from the second peripheral region 19b of the peripheral semiconductor portion 19. Moreover, the light blocking film 61a in superimposition on the separator 20A and the light blocking film 61a in superimposition on the separator 20B are also electrically separated from the peripheral semiconductor portion 19 between the separators 20A and 20B.

Therefore, the second peripheral region 19b of the peripheral semiconductor portion 19 can be shared as an application region to which a potential different from the potential supplied to the first peripheral region 19a of the peripheral semiconductor portion 19 is applied. In the first embodiment, because the second peripheral region 19b includes the p-type semiconductor region, the second peripheral region 19b can be shared as a first reference potential such as the ground potential. In a case where the second peripheral region 19b includes an n-type semiconductor region, the second peripheral region 19b can be shared as a second reference potential higher than the first reference potential, such as Vdd.

Note that in the first embodiment, described has been the case where the first peripheral region 19a and the second peripheral region 19b of the peripheral semiconductor portion 19 are electrically separated by the two separators 20A and 20B; however, a single separator 20 may be provided, or three or more separators 20 may be provided. In order to cause such a separator 20 to function as a guard ring, it is preferable to provide two or more separators from the viewpoint of reliability.

### (Other Configurations)

As illustrated in Figs. 5 to 7, the planarization film 62 is provided over the pixel region 2A and the peripheral region 2B in plan view, and covers the entirety of the side of the second face S2 of the semiconductor layer 10 including the light blocking films 61 and 61a such that the side of the light incident face (second face S2) of the semiconductor layer 10 is a flat face without unevenness. As the planarization film 62, for example, a silicon oxide film is used.

As illustrated in Figs. 5 to 7, the microlens layer 63 includes a plurality of microlens portions 63a arranged in the pixel region 2A and a flat portion 63b disposed in the peripheral region 2B. Each of the microlens portion 63a of the plurality of microlens portions 63a is arranged one-to-one in a matrix corresponding to the pixels 3 of the plurality of pixels 3, that is, the photoelectric converters 29 of the plurality of photoelectric converters 29 in the pixel region 2A. The microlens portions 63a each condense irradiation light and allows the condensed light to efficiently enter the photoelectric converter 29 of the corresponding pixel 3. The plurality of microlens portions 63a is included in a microlens array on the side of the second face S2 of the semiconductor layer 11. The microlens layer 63 includes, for example, a resin-based material such as STSR or CSiL.

As illustrated in Fig. 7, the selection insulating film 21 is provided over the pixel region 2A and the peripheral region 2B, and covers the entire first face S1 side of the peripheral semiconductor portion 19. Thus, the second semiconductor portion 24 is selectively provided on the first semiconductor portion 14 of the pixel region 2A, but is not provided on the peripheral region 2B.

### <<Effects of First Embodiment>>

Next, main effects of the first embodiment will be described.

In the conventional photoelectric converter, sensitivity to near-infrared light can be increased by increasing the thickness of a semiconductor portion (semiconductor layer). However, a light absorber and a multiplier are included in a single semiconductor portion. Thus, an increase in the thickness of the semiconductor portion results in deterioration of timing jitter characteristics important as ToF. That is, in the conventional distance image sensor, the sensitivity to near-infrared light and the timing jitter characteristics have been in a trade-off relationship.

On the other hand, in such a photoelectric converter 29 as described in the first embodiment, as illustrated in Fig. 6, the multiplier 15 is included in the first semiconductor portion 14 including Si. The light absorber 25 is included in the second semiconductor portion 24 including a germanium-based material (SiGe) narrower in band gap and higher (better) in sensitivity to near-infrared light than the first semiconductor portion 14. This arrangement enables improvement in sensitivity to near-infrared light without an increase in the thickness of the entire semiconductor portion including the first semiconductor portion 14 and the second semiconductor portion 24. Further, the sensitivity to near-infrared light can be improved without an increase in the thickness of the entire semiconductor portion, which enables suppression of deterioration of the timing jitter characteristics due to an increase in the thickness of the semiconductor portion. Therefore, the distance image sensor 1 according to the first embodiment can improve sensitivity to near-infrared light and suppress deterioration of timing jitter.

Further, the distance image sensor 1 according to the first embodiment has the first face S1 of the peripheral semiconductor portion 19 covered with the selection insulating film 21 that selectively forms the second semiconductor portion 24 on the first face S1 of the first semiconductor portion 14. Therefore, in the distance image sensor 1 according to the first embodiment, the second semiconductor portion 24 can be selectively formed on the side of the first face S1 of the first semiconductor portion 14 without forming the second semiconductor portion 24 on the peripheral semiconductor portion 19.

Furthermore, the distance image sensor 1 according to the first embodiment includes the separator 13 and the light blocking film 61 as a conductive path that electrically connects the contact electrode 34b provided on the side of the first face S1 of the first semiconductor portion 14 and the n-type second semiconductor region 17 provided on the side of the second face S2 of the first semiconductor portion 14. Therefore, in the distance image sensor 1 according to the first embodiment, constructed can be a conductive path that electrically connects the contact electrode 34b provided on the side of the first face S1 of the first semiconductor portion 14 and the n-type second semiconductor region 17 provided on the side of the second face S2 opposite to the side of the first face S1 of the first semiconductor portion 14 without reducing the occupied area of the photoelectric converter 29 in a single pixel 3.

Still furthermore, in the distance image sensor 1 according to the first embodiment, the multi-level wiring layer 31 of the first semiconductor base 10 and the multi-level wiring layer 51 of the second semiconductor base 40 are connected, respectively, through the metal pads of the multi-level wiring layer 31 and the metal pads of the multi-level wiring layer 51 (the metal pads 37a and 57a, and the metal pads 37b and 57b). Therefore, in the distance image sensor 1 according to the first embodiment, the readout circuit can be provided on the second semiconductor base 40 different from the first semiconductor base 10 provided with the photoelectric converter 29, and it is not necessary to provide a readout circuit on the first semiconductor base 10. As a result, the occupied area of the photoelectric converter 29 in a single pixel 3 can be increased and sensitivity can be improved.

Note that in the above first embodiment, described has been the case where the second semiconductor portion 24 having the two-layer structure in which the intrinsic semiconductor layer 26 including the compound of Si and Ge and the p-type extrinsic semiconductor layer 27 including the compound of Si and Ge are disposed in order from the side of the first semiconductor portion 14. The present technology, however, is not limited to such a compound of SiGe as described above. For example, the second semiconductor portion 24 may have a two-layer structure in which an intrinsic semiconductor layer that includes Ge and a p-type exogenous semiconductor layer that includes Ge and has the same conductivity type as the p-type first semiconductor region 16 of the first semiconductor portion 14 may be disposed in order from the side closer to the first semiconductor portion 14. Also in this case, effects similar to those of the above first embodiment can be obtained. The intrinsic semiconductor layer including Ge can be selectively formed by an epitaxial growth method, similarly to the above intrinsic semiconductor layer 26. Further, the extrinsic semiconductor layer including Ge can be formed by an epitaxial growth method or an ion implantation method, similarly to the extrinsic semiconductor layer 27 described above.

Still furthermore, in the above first embodiment, the second semiconductor portion 24 having the rectangular planar pattern has been described. The second semiconductor portion 24, however, may have a circular planar pattern. Also in this case, effects similar to those of the distance image sensor 1 of the above first embodiment can be obtained.

### [Second Embodiment]

A distance image sensor according to a second embodiment of the present technology is basically similar in configuration to the distance image sensor 1 according to the above first embodiment, but is different in configuration of a photoelectric converter.

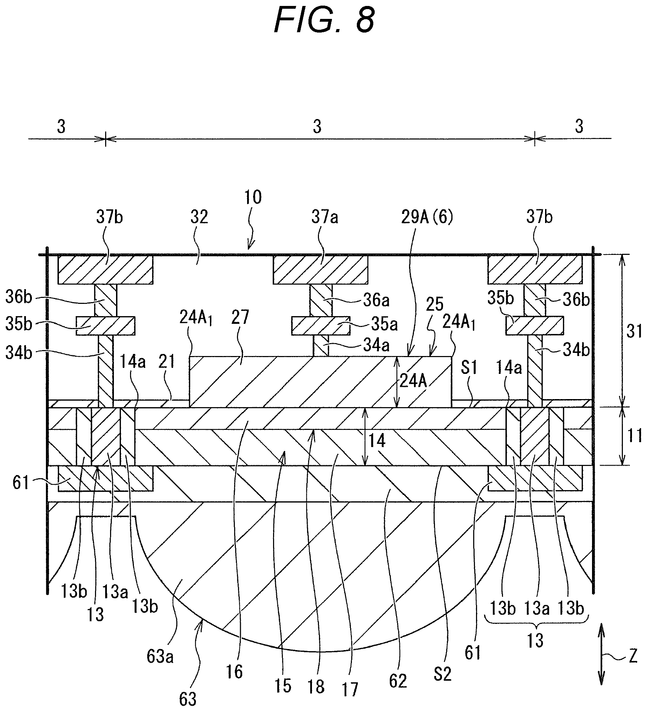

That is, as illustrated in Fig. 8, a photoelectric converter 29A of the second embodiment includes a second semiconductor portion 24A instead of the second semiconductor portion 24 of the photoelectric converter 29 illustrated in Fig. 6. Other configurations are similar to those in the above first embodiment.

As illustrated in Fig. 8, the second semiconductor portion 24A of the second embodiment includes a compound of SiGe, and includes a single layer of a p-type extrinsic semiconductor layer 27 having the same conductivity type as a p-type first semiconductor region 16 of a first semiconductor portion 14. Similarly to the second semiconductor portion 24 of the above first embodiment, the second semiconductor portion 24A has a contour 24A₁ in plan view is located inside a contour 14a of the first semiconductor portion 14.

Further, the second semiconductor portion 24A is formed on the side of a first face S1 of the first semiconductor portion 14 due to self-alignment to a selection insulating film 21, and is covalently bonded with the p-type first semiconductor region 16 of the first semiconductor portion 14. In addition, a light absorber 25 is provided at the second semiconductor portion 24A.

The second semiconductor portion 24A having such a configuration is narrower in band gap and higher in sensitivity to near-infrared light than the first semiconductor portion 14 including Si. Therefore, at the photoelectric converter 29A of the second embodiment, sensitivity to near-infrared light can be improved without an increase in the thickness of the entire semiconductor portion including the first semiconductor portion 14 and the second semiconductor portion 24. Further, the sensitivity to near-infrared light can be improved without an increase in the thickness of the entire semiconductor portion, which enables suppression of deterioration of the timing jitter characteristics due to an increase in the thickness of the semiconductor portion. As a result, also the distance image sensor according to the second embodiment can obtain effects similar to those of the distance image sensor 1 according to the above first embodiment.

Note that the second semiconductor portion 24A may include a single layer of a p-type extrinsic semiconductor layer including Ge. Also in this case, effects similar to those of the distance image sensor 1 of the above first embodiment can be obtained.

### [Third Embodiment]

A distance image sensor according to a third embodiment of the present technology is basically similar in configuration to the distance image sensor 1 according to the above first embodiment, but is different in configuration of a pixel.

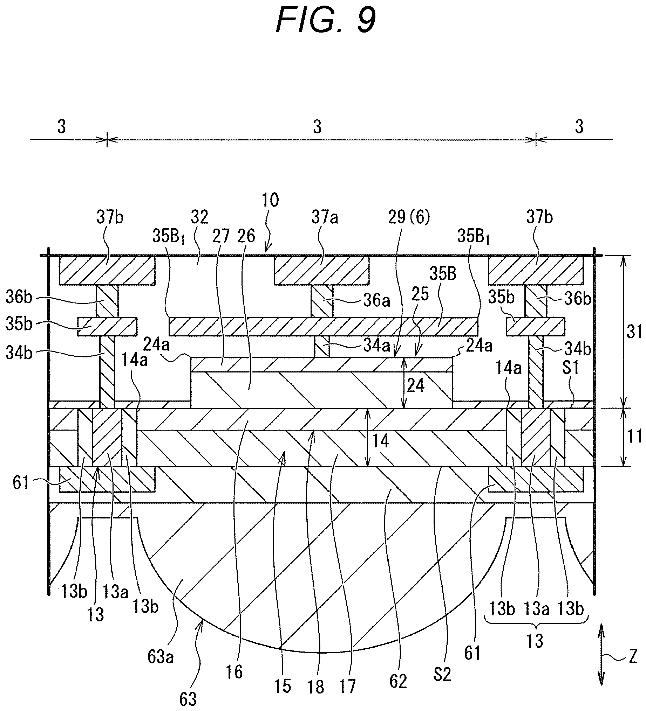

That is, as illustrated in Fig. 9, a pixel 3 of the third embodiment includes a first metal wired line 35B instead of the first metal wired line 35a illustrated in Fig. 6. Other configurations are similar to those in the above first embodiment.

As illustrated in Fig. 9, the first metal wired line 35B of the third embodiment is provided in superimposition on a second semiconductor portion 24 in plan view on the side opposite to the side closer to a first semiconductor portion 14 (side of a first face S1 of the first semiconductor portion 14) of the second semiconductor portion 24, and has a contour 35B₁ in plan view is located outside a contour 24a of the second semiconductor portion 24. Further, the first metal wired line 35B is electrically connected to a p-type extrinsic semiconductor layer 27 of the second semiconductor portion 24 through a contact electrode 34a, and is electrically connected to a metal pad 37a through a contact electrode 36a.

In a pixel 3 of the second embodiment, light having entered from the side of the light incident face as the side of a second face S2 of the first semiconductor portion 14 and having passed through a photoelectric converter 29 is reflected from the first metal wired line 35B and returns to the photoelectric converter 29. Thus, the quantum efficiency of the photoelectric converter 29 (APD element 6) can be improved due to the reflection effect of the first metal wired line 35B. Therefore, the distance image sensor according to the second embodiment can obtain effects similar to those of the distance image sensor 1 according to the above first embodiment, and the quantum efficiency of the photoelectric converter 29 can be further improved.

Note that in order to ensure the insulation resistance between the first metal wired line 35B and a second metal wired line 35b, it is preferable that the first metal wired line 35B has a planar pattern in which the contour 35B₁ in plan view is located inside a contour 14a of the first semiconductor portion 14.

### [Fourth Embodiment]

A distance image sensor according to a fourth embodiment of the present technology is basically similar in configuration to the distance image sensor 1 according to the above first embodiment, but is different in configuration of a photoelectric converter.

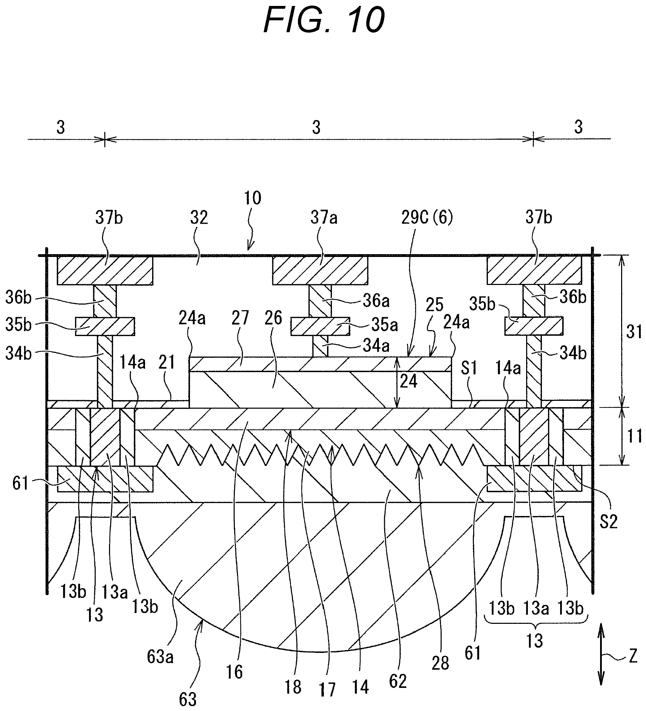

That is, as illustrated in Fig. 10, a photoelectric converter 29C of the fourth embodiment further includes a light reflector 28 uneven in shape provided on the side of a second face S2 of a first semiconductor portion 14. Other configurations are similar to those in the above first embodiment.

The light reflector 28 can diffusely reflect light having entered from the side of the second face S2 of the first semiconductor portion 14 to the side of a first face S1 thereof, which enables the amount of light incident on the second semiconductor portion 24 to be made uniform in a two-dimensional plane, and sensitivity can be improved. Therefore, the distance image sensor according to the fourth embodiment can obtain effects similar to those of the above distance image sensor 1, and the sensitivity can be further improved.

### [Fifth Embodiment]

A distance image sensor according to a fifth embodiment of the present technology is basically similar in configuration to the distance image sensor 1 according to the above first embodiment, but is different in configuration of a photoelectric converter.

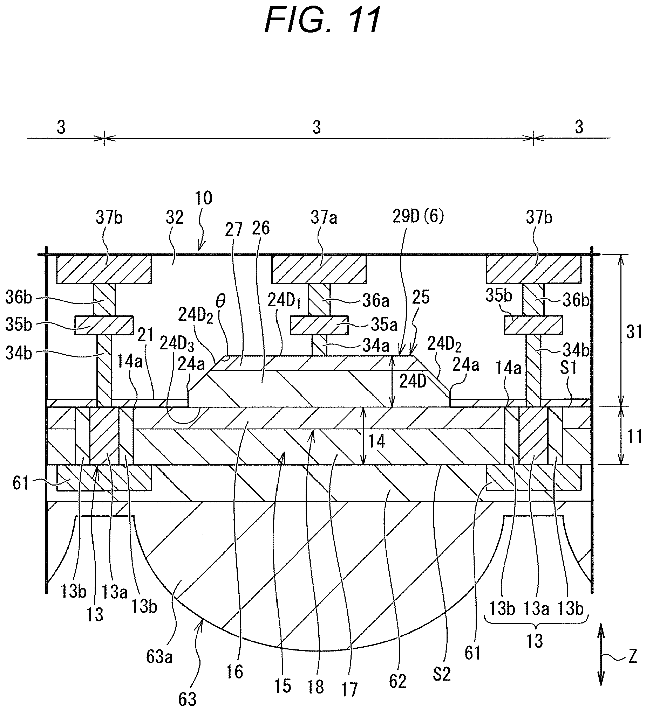

That is, as illustrated in Fig. 11, a photoelectric converter 29D of the fifth embodiment includes a second semiconductor portion 24D instead of the second semiconductor portion 24 of the photoelectric converter 29 illustrated in Fig. 6. Other configurations are similar to those in the above first embodiment.

As illustrated in Fig. 11, the second semiconductor portion 24D of the fifth embodiment has an upper face 24D₁ and a side face 24D₂, and the side face 24D₂ inclines such that the internal angle θ between the upper face 24D₁ and the side face 24D₂ is obtuse. In other words, the side face 24D₂ of the second semiconductor portion 24D inclines such that the upper face 24D₁ of the second semiconductor portion 24D is smaller in area than a lower face 24D₃.

In the photoelectric converter 29D of the fifth embodiment, light having entered from the side of a light incident face (side of a second face S2 side) of a first semiconductor portion 14 passes through the first semiconductor portion 14 and enters the second semiconductor portion 24D. Then, the light having entered the second semiconductor portion 24D is reflected inward by the side face 24D₂ of the second semiconductor portion 24D, so that the light absorption rate at a light absorber 25 (second semiconductor portion 24) can be improved. Therefore, the distance image sensor according to the fifth embodiment can obtain effects similar to those of the distance image sensor 1 according to the above first embodiment, and the light absorption rate at the light absorber 25 can be improved.

Note that the side face 24D₂ of the second semiconductor portion 24D can be easily inclined by selectively growing the second semiconductor portion 24D on the first semiconductor portion 14 by an epitaxial growth method.

### [Sixth Embodiment]

A distance image sensor according to a sixth embodiment of the present technology is basically similar in configuration to the distance image sensor 1 according to the above first embodiment, bur is different configuration of a photoelectric converter.

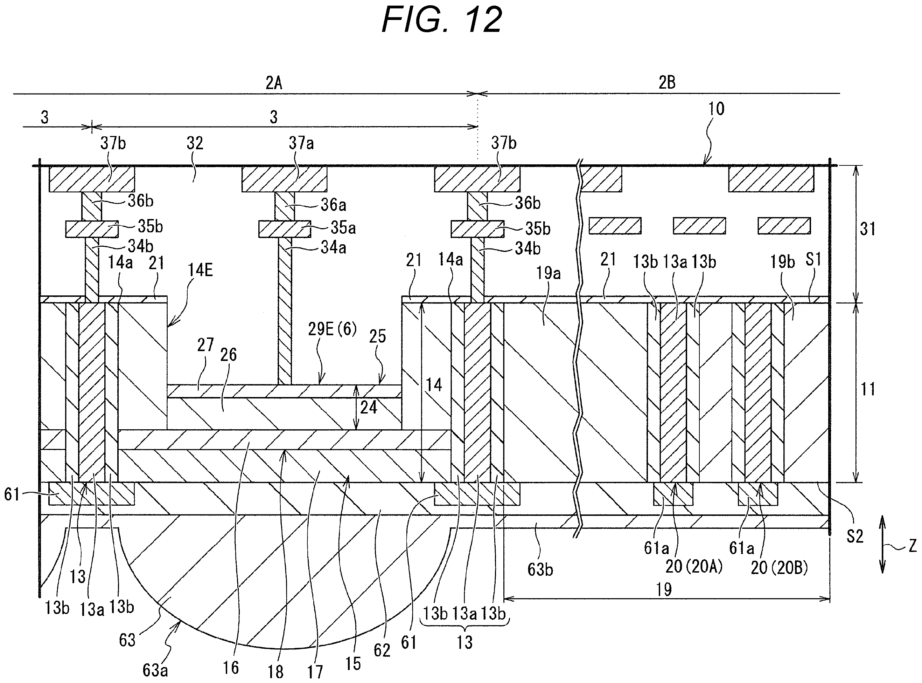

That is, as illustrated in Fig. 12, a photoelectric converter 29E according to the sixth embodiment includes a first semiconductor portion 14 provided with a groove 14E extending from the side of a first face S1 to the side of a second face S2 of the first semiconductor portion 14. In addition, a p-type first semiconductor region 16 and an n-type second semiconductor region 17 are provided in superimposition on the groove 14E closer to the side of the second face S2 of the first semiconductor portion 14 than the groove 14E is. Further, a second semiconductor portion 24 is disposed in the groove 14E, and an intrinsic semiconductor layer 26 is covalently bonded with the p-type first semiconductor region 16 of the first semiconductor portion 14 at the bottom of the groove 14E. Furthermore, a selection insulating film 21 covers the side of a first face S1 of a semiconductor layer 11 including the first semiconductor portion 14 and a peripheral semiconductor portion 19 except for the groove 14E. Still furthermore, the first semiconductor portion 14 and the peripheral semiconductor portion 19 are thicker in thickness as comparison with the first embodiment. Still furthermore, along with the thickness, a separator 13 and a separator 20 extend long in the thickness direction of the semiconductor layer 11. Other configurations are similar to those in the above first embodiment.

In the distance image sensor according to the sixth embodiment, the mechanical strength of the first semiconductor portion 14 and the peripheral semiconductor portion 19, in other words, the mechanical strength of the semiconductor layer 11 can be increased as compared with a case where the entire semiconductor layer 11 is thinned as in the first embodiment.

In addition, the thickness of the entire semiconductor portion including the first semiconductor portion 14 and the second semiconductor portion 24 at the photoelectric converter 29E can be reduced with the mechanical strength of the first semiconductor portion 14 and the peripheral semiconductor portion 19 secured.

Furthermore, in the distance image sensor according to the sixth embodiment, the second semiconductor portion 24 can be selectively formed on the side of the first face S1 of the first semiconductor portion 14 in the groove 14E without forming the second semiconductor portion 24 on the peripheral semiconductor portion 19.

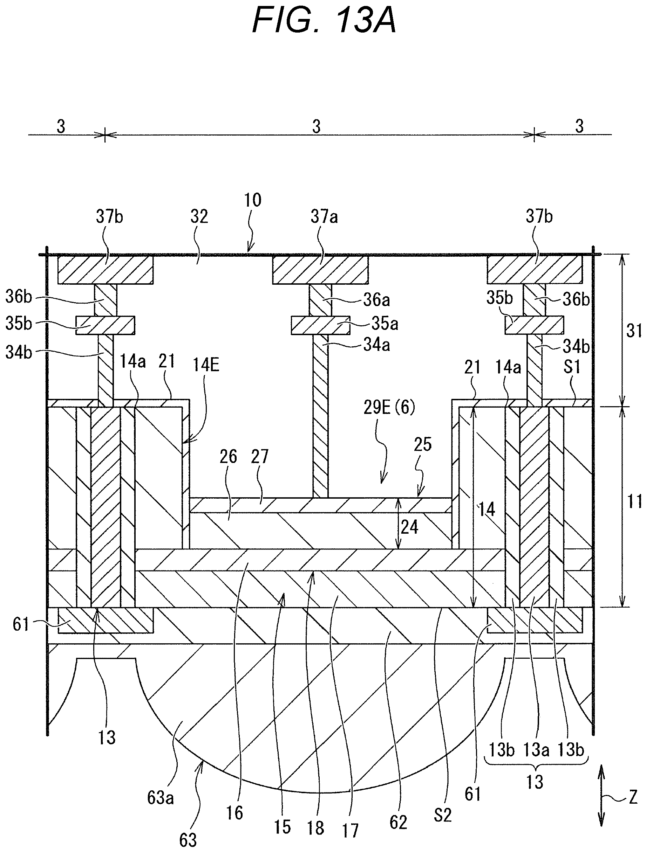

Note that as a first modification of the sixth embodiment, a selection insulating film 21 may be formed on a sidewall of a groove 14E as illustrated in Fig. 13A.

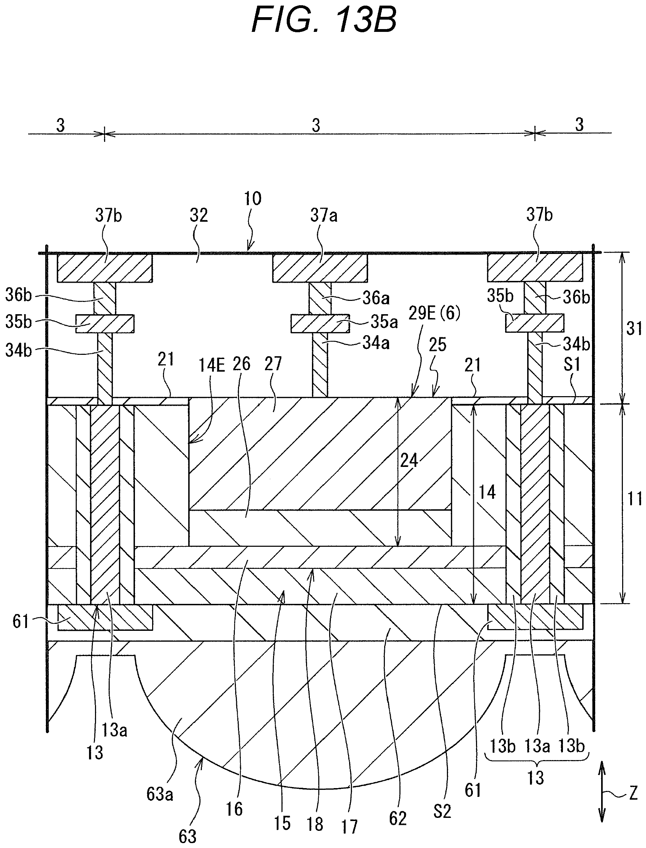

Alternatively, as a second modification of the sixth embodiment, a second semiconductor portion 24 may be embedded in a groove 14E so as to be exposed from the groove 14E as illustrated in Fig. 13B.

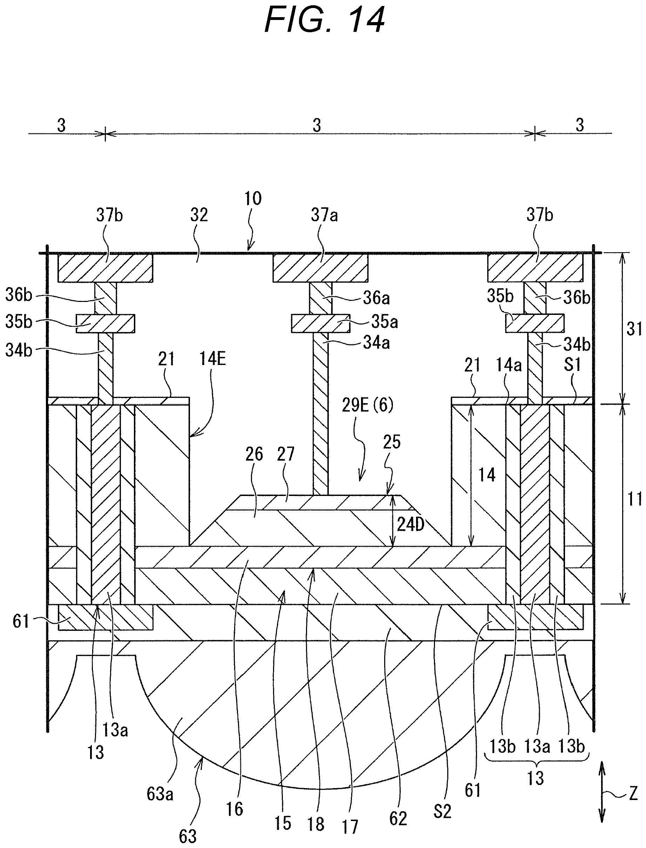

Alternatively, as a third modification of the sixth embodiment, such a second semiconductor portion 24D as described in the fifth embodiment may be provided in a groove 14E instead of a second semiconductor portion 24 as illustrated in Fig. 14.

### [Seventh Embodiment]

A distance image sensor according to a seventh embodiment of the present technology is basically similar in configuration to the distance image sensor 1 according to the above first embodiment, but is different in configuration of a photoelectric converter.

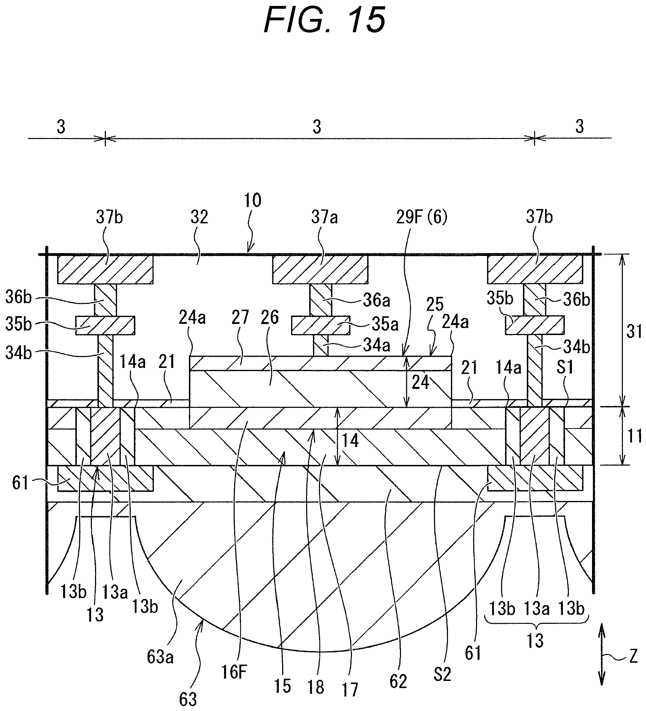

That is, as illustrated in Fig. 15, a photoelectric converter 29F of the seventh embodiment includes a p-type first semiconductor region 16F instead of the p-type first semiconductor region 16 illustrated in Fig. 6. Other configurations are similar to those in the above first embodiment.

As illustrated in Fig. 15, the p-type first semiconductor region 16F of the seventh embodiment is spaced apart from a separator 13. In addition, the p-type first semiconductor region 16F is spaced apart from the separator 13, and thus a pn junction 18 in which an avalanche multiplication region is formed is spaced apart from the separator 13. Further, a contact electrode 34b is connected to a separation conductor 13a of the separator 13.

As described above, the p-type first semiconductor region 16F is spaced apart from the separator 13, and thus the pn junction 18 in which the avalanche multiplication region is formed is spaced apart from the separator 13. As a result, avalanche multiplication due to dark current generated at the interface between a first semiconductor portion 14 and the separator 13 can be suppressed.

Therefore, the distance image sensor according to the seventh embodiment can obtain effects similar to those of the distance image sensor 1 according to the above first embodiment, and avalanche multiplication due to dark current can be suppressed.

### [Eighth Embodiment]

A distance image sensor according to an eighth embodiment of the present technology is basically similar in configuration to the distance image sensor according to the above seventh embodiment, but is different in configuration of a photoelectric converter.

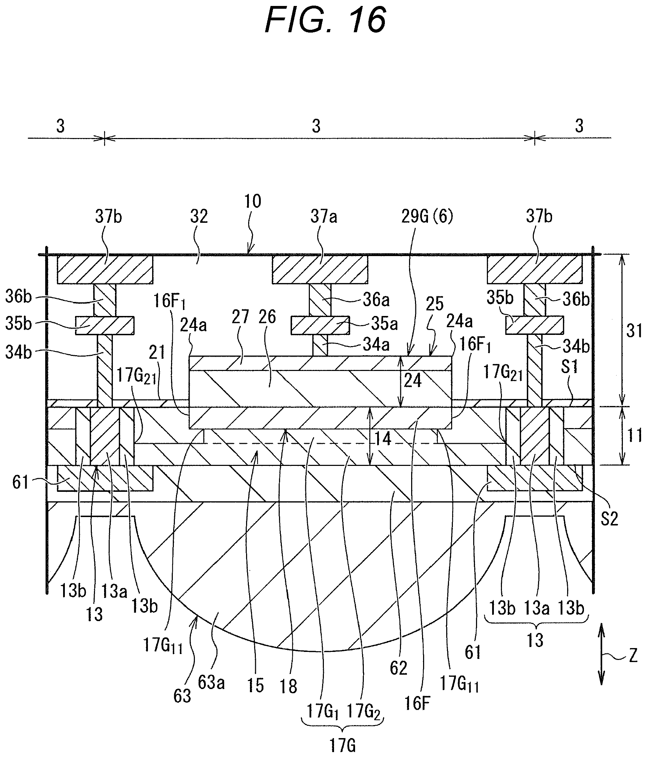

That is, as illustrated in Fig. 16, a photoelectric converter 29G of the eighth embodiment includes an n-type second semiconductor region 17G instead of the n-type second semiconductor region 17 of the seventh embodiment illustrated in Fig. 15. Other configurations are similar to those in the above seventh embodiment.

As illustrated in Fig. 16, the n-type second semiconductor region 17G of the eighth embodiment is provided at a position deeper than the position of a p-type first semiconductor region 16F with respect to the side of a first face S1 of a first semiconductor portion 14, the n-type second semiconductor region 17G and the bottom of the p-type first semiconductor region 16F forms a pn junction 18, and the n-type second semiconductor region 17G includes a first portion 17G₁ having a contour 17G₁₁ in plan view located inside a contour 16F₁ of the p-type first semiconductor region 16F. In addition, the n-type second semiconductor region 17G includes a second portion 17G₂ provided at a position deeper than the position of the first portion 17G₁ with respect to the side of the first face S1 of the first semiconductor portion 14, and has a contour 17G₂₁ in plan view located outside the contour 16F₁ of the p-type first semiconductor region 16F. The outermost periphery (contour 17G₂₁) of the second portion 17G₂ is in contact with a separator 13. Further, the contour 17G₁₁ of the first portion 17G₁ is located inside the contour 16F₁ of the p-type first semiconductor region 16F, and thus the pn junction 18 is located inside the contour 16F₁ of the p-type semiconductor region 16F.

As described above, the n-type second semiconductor region 17G is provided such that the first portion 17G₁ forming the pn junction 18 with the p-type first semiconductor region 16F is located inside the contour 16F₁ of the p-type first semiconductor region 16F in plan view, and thus the pn junction 18 is located inside the contour 16F₁ of the p-type first semiconductor region 16F. Thus, a high electric field at the edge portion (contour 16F₁) of the p-type first semiconductor region 16F is avoidable. With this arrangement, avalanche multiplication biased to the edge portion of the p-type first semiconductor region 16F can be suppressed and avalanche multiplication can be made uniform over the entire pn junction 18, so that the light detection efficiency can be enhanced.

Therefore, the distance image sensor according to the eighth embodiment can obtain effects similar to those of the distance image sensor according to the seventh embodiment, and the light absorption rate can be enhanced.

### [Ninth Embodiment]

A distance image sensor according to a ninth embodiment of the present technology is basically similar in configuration to the distance image sensor 1 according to the above first embodiment, but is different in configuration of a pixel.

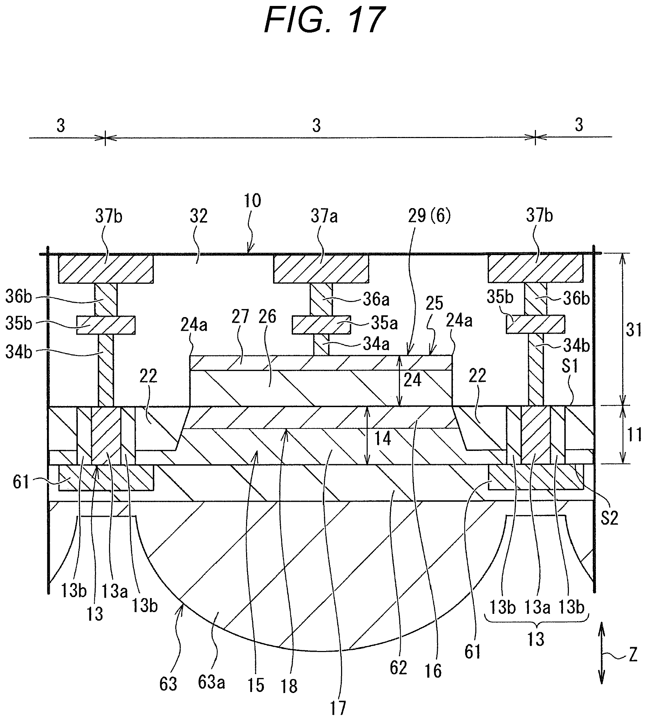

That is, as illustrated in Fig. 17, a pixel 3 of the ninth embodiment includes a selection insulating film 22 instead of the selection insulating film 21 of the first embodiment illustrated in Fig. 6. Other configurations are similar to those in the first embodiment.

As illustrated in Fig. 17, the selection insulating film 22 of the ninth embodiment is an embedded type and embedded in a first semiconductor portion 14 so as to be exposed from a first face S1 of the first semiconductor portion 14. The selection insulating film 22 can be formed, for example, by forming a groove in the first semiconductor portion 14, forming an insulating film on the first semiconductor portion 14 so as to fill the groove, and then selectively removing the insulating film on the first semiconductor portion 14 such that the insulating film remains in the groove. The insulating film selectively formed in the groove in such a manner is called a shallow trench isolation (STI) structure.

The selection insulating film 22 is selectively provided on the first semiconductor portion 14 outside a second semiconductor portion 24 except for the first semiconductor portion 14 immediately below the second semiconductor portion 24. Further, although not illustrated, similarly to the selection insulating film 21 of the first embodiment, the selection insulating film 22 is provided over a pixel region 2A and a peripheral region 2B, and covers the side of a first face S1 of the entire peripheral semiconductor portion 19. Therefore, also in the distance image sensor according to the ninth embodiment, similarly to the distance image sensor 1 according to the first embodiment, the second semiconductor portion 24 can be selectively formed on the side of the first face S1 of the first semiconductor portion 14 without forming the second semiconductor portion 24 on the peripheral semiconductor portion 19.

### [Tenth Embodiment]

A distance image sensor according to a tenth embodiment of the present technology is basically similar in configuration to the distance image sensor according to the above ninth embodiment, but is different in configuration of a photoelectric converter.

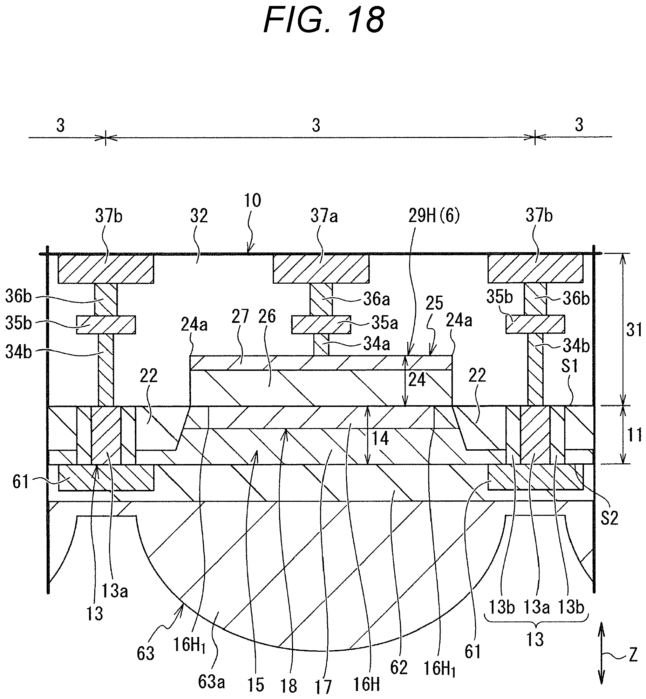

That is, as illustrated in Fig. 18, a photoelectric converter 29H of the tenth embodiment includes a p-type first semiconductor region 16H instead of the p-type first semiconductor region 16 of the ninth embodiment illustrated in Fig. 17. Other configurations are similar to those in the above ninth embodiment.

As illustrated in Fig. 18, the p-type first semiconductor region 16H of the tenth embodiment is spaced apart from a selection insulating film 22. The p-type first semiconductor region 16H has a contour 16H₁ in plan view located inside a contour 24a of a second semiconductor portion 24. Further, the p-type first semiconductor region 16H is spaced apart from a selection insulating film 22, and thus a pn junction 18 in which an avalanche multiplication region is formed is spaced apart from the selection insulating film 22.

As described above, the p-type first semiconductor region 16H is separated from the selection insulating film 22, and thus the pn junction 18 in which the avalanche multiplication region is formed is spaced apart from the selection insulating film 22. As a result, avalanche multiplication due to dark current generated at the interface between the first semiconductor portion 14 and the selection insulating film 22 can be suppressed.

Therefore, the distance image sensor according to the tenth embodiment can obtain effects similar to those of the distance image sensor 1 according to the above first embodiment, and avalanche multiplication due to dark current can be suppressed.

### [Eleventh Embodiment]

A distance image sensor according to an eleventh embodiment of the present technology is basically similar in configuration to the distance image sensor according to the above tenth embodiment, but is different in configuration of a photoelectric converter.

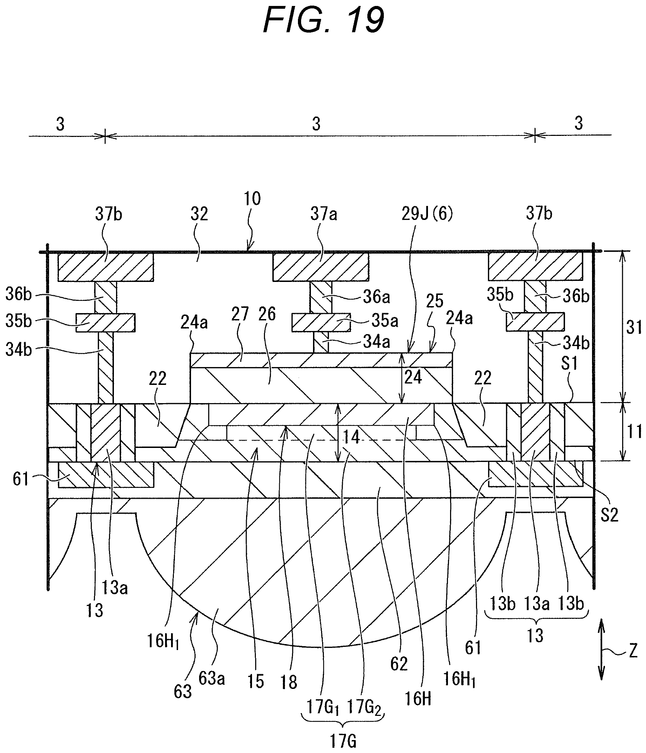

That is, as illustrated in Fig. 19, a photoelectric converter 29J of the eleventh embodiment includes such an n-type semiconductor region 17G as described in the eighth embodiment illustrated in Fig. 16 instead of the n-type second semiconductor region 17 of the tenth embodiment illustrated in Fig. 18. Other configurations are similar to those in the tenth embodiment.

Also in the photoelectric converter 29J, a pn junction 18 is located inside a contour 16H₁ of a p-type first semiconductor region 16H. Thus, a high electric field at the edge portion (contour 16H₁) of the p-type first semiconductor region 16H is avoidable. As a result, avalanche multiplication biased to the edge portion of the p-type first semiconductor region 16H can be suppressed and avalanche multiplication can be made uniform over the entire pn junction 18. Thus, the light detection efficiency can be enhanced.

Therefore, the distance image sensor according to the eleventh embodiment can obtain effects similar to those of the distance image sensor according to the tenth embodiment, and the light detection efficiency can be enhanced.

### [Twelfth Embodiment]

A distance image sensor according to a twelfth embodiment of the present technology is basically similar in configuration to the distance image sensor according to the above ninth embodiment, but is different in configuration of a pixel.

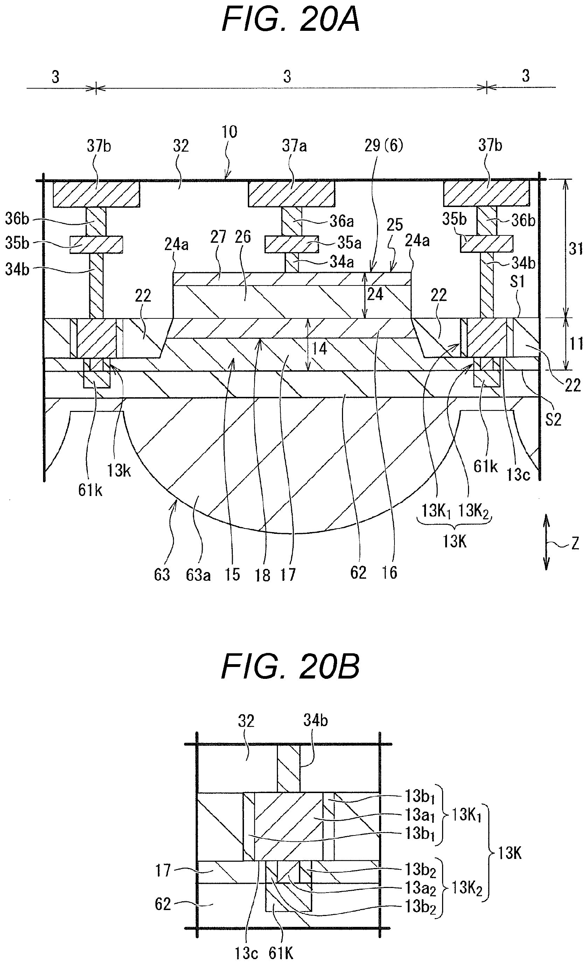

That is, as illustrated in Fig. 20A, a pixel 3 of the twelfth embodiment includes a separator 13K and a light blocking film 61K instead of the separator 13 and the light blocking film 61 of the ninth embodiment illustrated in Fig. 17. Further, an n-type second semiconductor region 17 and the separator 13K are electrically connected in a different connection form.

As illustrated in Fig. 20A, the separator 13K includes a first portion 13K₁ provided on the side of a first face S1 of a first semiconductor layer 11, and a second portion 13K₂ that is provided in series connection with the first portion 13K₁ at a position deeper than the position of the first portion 13K₁ and is narrower in width than the first portion 13K₁.

As illustrated in Fig. 20B, similarly to the above separator 13, the first portion 13K₁ includes a separation conductor 13a₁ extending in the thickness direction (Z direction) of a first semiconductor portion 14 and a separation insulator 13b₁ covering a side face on either side of the separation conductor 13a₁. In addition, similarly to the above separator 13, the second portion 13K₂ includes a separation conductor 13a₂ extending in the thickness direction (Z direction) of the first semiconductor portion 14 and a separation insulator 13b₂ covering a side face on either side of the separation conductor 13a₂. Further, the separation conductor 13a₁ of the first portion 13K₁ is wider in width than the separation conductor 13a₂ of the second portion 13K₂. Still furthermore, the separator 13K including the first portion 13K₁ and the second portion 13K₂ extends over a first face S1 and a second face S2 of the first semiconductor portion 14. The separation conductors 13a₁ and 13a₂ each include a metal film excellent in light reflectivity and conductivity, for example, a tungsten (W) film. The separation insulators 13b₁ and 13b₂ each include an insulating film excellent in insulation, for example, a silicon oxide (SiO₂) film.

The separator 13K includes a step portion 13c due to the difference in width between the separation conductor 13a₁ of the first portion 13K₁ and the separation conductor 13a₂ of the second portion 13K₂. In addition, a peripheral portion of an n-type second semiconductor region 17 is electrically and mechanically connected to the step portion 13c. That is, the n-type second semiconductor region 17 is electrically and mechanically connected to the separation conductors (13a₁ and 13a₂) of the separator 13K closer to the first face S1 of the first semiconductor portion 14 than the second face S2 of the first semiconductor portion 14. In other words, the n-type second semiconductor region 17 is electrically and mechanically connected to the separation conductors (13a₁ and 13a₂) of the separator 13K in the middle between the side of one end and the side of the other end of the separator 13K.

As illustrated in Figs. 20A and 20B, similarly to the above light blocking film 61, the light blocking film 61K has a lattice-shaped planar pattern in which a photoelectric converter 29 has an opening on the side of its light-receiving face in a planar pattern in plan view such that light from a predetermined pixel 3 does not leak into the adjacent pixel 3. Further, unlike the above light blocking film 61, the light blocking film 61K is different from the above light blocking film 61 in that the width is narrower than that of the separator 13K. That is, the light blocking film 61K of the twelfth embodiment has a light blocking function, but does not have a function as a relay electrode unlike the above light blocking film 61. The light blocking film 61K includes, for example, a composite film in which a titanium (Ti) film and a tungsten (W) film are layered in this order from the side closer to a semiconductor layer 10.

The distance image sensor according to the twelfth embodiment having such a configuration can obtain effects similar to those of the distance image sensor 1 according to the above first embodiment.

Further, in the distance image sensor according to the twelfth embodiment, the n-type second semiconductor region 17 is electrically and mechanically connected to the separation conductors (13a₁ and 13a₂) of the separator 13K closer to the first face S1 of the first semiconductor portion 14 than the second face S2 of the first semiconductor portion 14. Thus, the light blocking film 61K can be made narrower in width than the light blocking film 61 of the above embodiment. As a result, the opening area of a photoelectric converter 29 can be increased, and the quantum efficiency (light receiving sensitivity) of the photoelectric converter 29 can be improved.

### [Thirteenth Embodiment]

A distance image sensor according to a thirteenth embodiment of the present technology is basically similar in configuration to the distance image sensor according to the above tenth embodiment, but is different in configuration of a pixel.

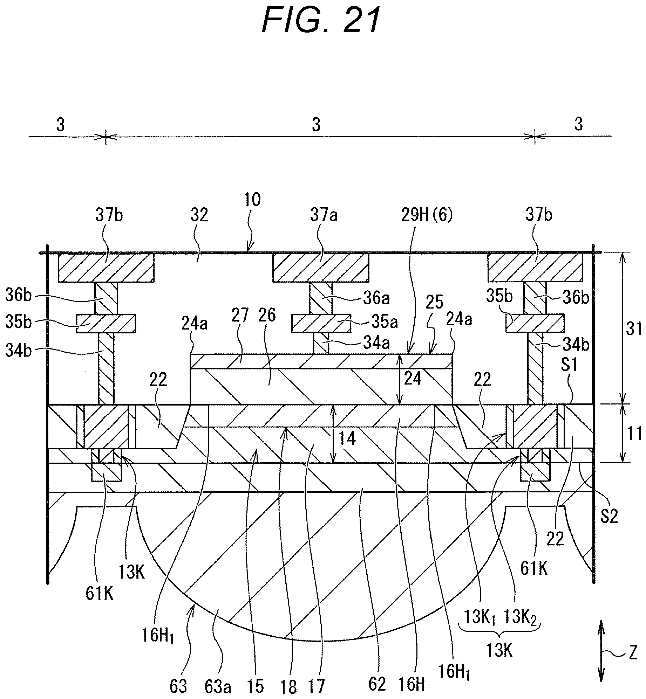

That is, as illustrated in Fig. 21, a pixel 3 of the thirteenth embodiment includes such a separator 13K and a light blocking film 61K as described in the twelfth embodiment illustrated in Fig. 20A and Fig. 20B instead of the separator 13 and the light blocking film 61 of the tenth embodiment in Fig. 18. Other configurations are similar to those in the above tenth embodiment.

The distance image sensor according to the thirteenth embodiment can obtain effects similar to those of the distance image sensor 1 according to the above first embodiment, and avalanche multiplication due to dark current can be suppressed. Further, the opening area of a photoelectric converter 29H can be increased, and the quantum efficiency (light receiving sensitivity) of the photoelectric converter 29H can be improved.

### [Fourteenth Embodiment]

A distance image sensor according to a fourteenth embodiment of the present technology is basically similar in configuration to the distance image sensor according to the above eleventh embodiment, but is different in configuration of a pixel.

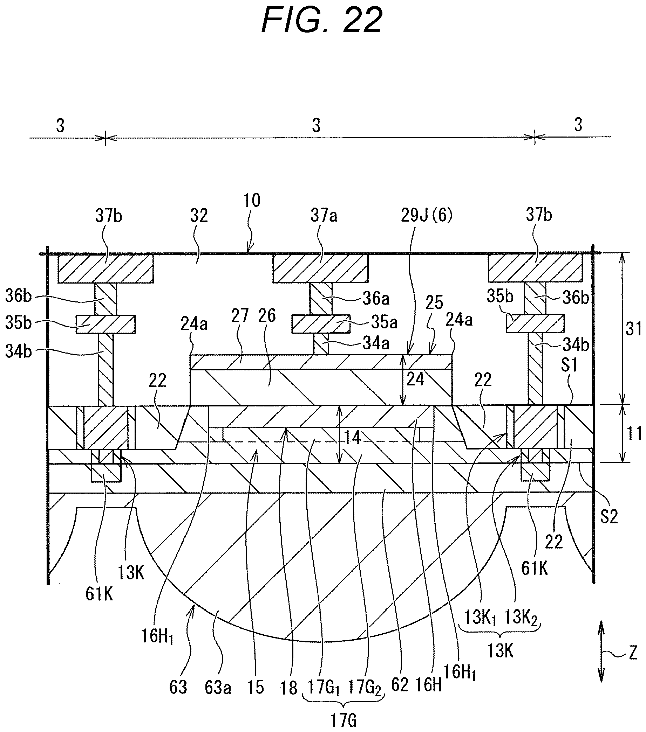

That is, as illustrated in Fig. 22, a pixel 3 of the fourteenth embodiment includes such a separator 13K and a light blocking film 61K as described in the twelfth embodiment illustrated in Figs. 20A and 20B instead of the separator 13 and the light blocking film 61 of the eleventh embodiment in Fig. 19. Other configurations are similar to those in the above eleventh embodiment.

The distance image sensor according to the fourteenth embodiment can obtain effects similar to those of the distance image sensor according to the eleventh embodiment, and the opening area of a photoelectric converter 29J can be increased. As a result, the quantum efficiency (light receiving sensitivity) of the photoelectric converter 29J can be improved.

### [Fifteenth Embodiment]

A distance image sensor according to a fifteenth embodiment of the present technology is basically similar in configuration to the distance image sensor 1 according to the above first embodiment, but is different in configuration of a pixel.

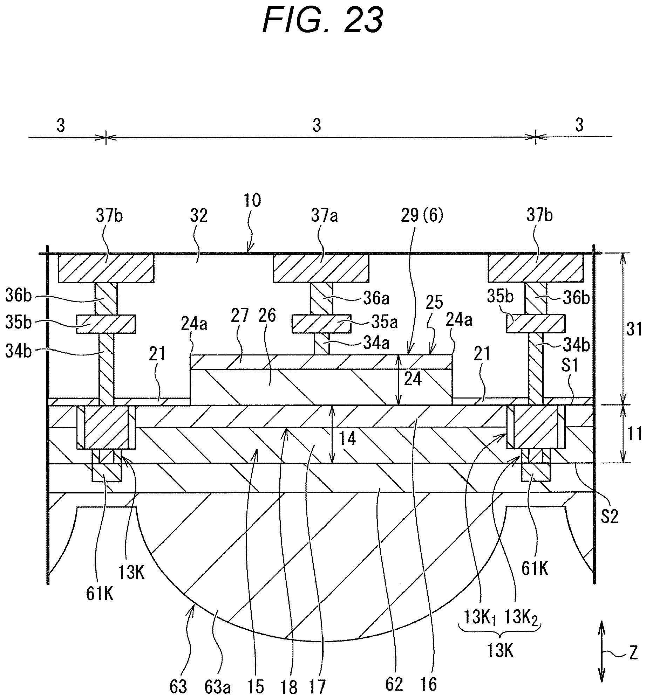

That is, as illustrated in Fig. 23, a pixel 3 of the fifteenth embodiment includes such a separator 13K and a light blocking film 61K as described in the twelfth embodiment illustrated in Figs. 20A and 20B instead of the separator 13 and the light blocking film 61 of the first embodiment in Fig. 6. Other configurations are similar to those in the above first embodiment.
the distance image sensor according to the fifteenth embodiment can obtain effects similar to those of the distance image sensor 1 according to the above first embodiment, and the opening area of a photoelectric converter 29 can be increased. As a result, the quantum efficiency (light receiving sensitivity) of the photoelectric converter 29 can be improved.

### [Sixteenth Embodiment]

A distance image sensor according to a sixteenth embodiment of the present technology is basically similar in configuration to the distance image sensor according to the above seventh embodiment, but is different in configuration of a pixel.

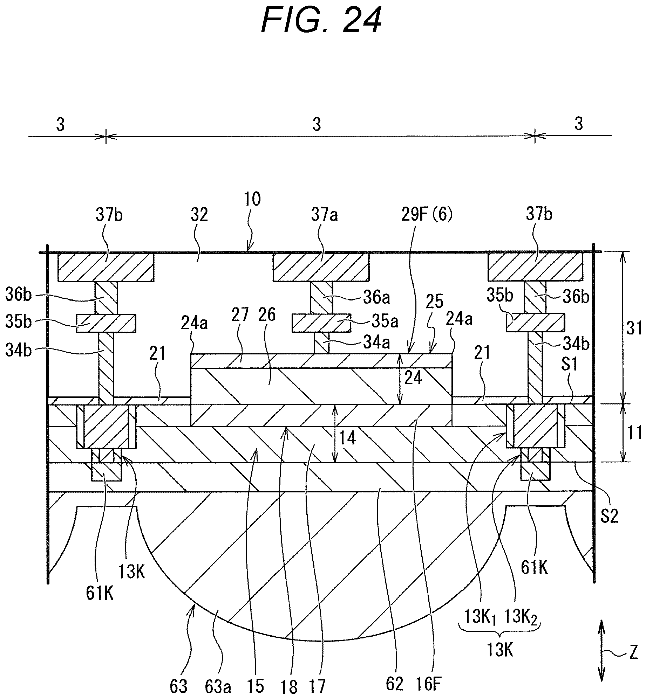

That is, as illustrated in Fig. 24, a pixel 3 of the sixteenth embodiment includes such a separator 13K and a light blocking film 61K as described in the twelfth embodiment illustrated in Figs. 20A and 20B instead of the separator 13 and the light blocking film 61 of the seventh embodiment in Fig. 15. Other configurations are similar to those in the above seventh embodiment.

The distance image sensor according to the sixteenth embodiment can obtain effects similar to those of the distance image sensor according to the above seventh embodiment, and the opening area of a photoelectric converter 29F can be increased. As a result, the quantum efficiency (light receiving sensitivity) of the photoelectric converter 29F can be improved.

### [Seventeenth Embodiment]

A distance image sensor according to a seventeenth embodiment of the present technology is basically similar in configuration to the distance image sensor according to the above eighth embodiment, but is different in configuration of a pixel.

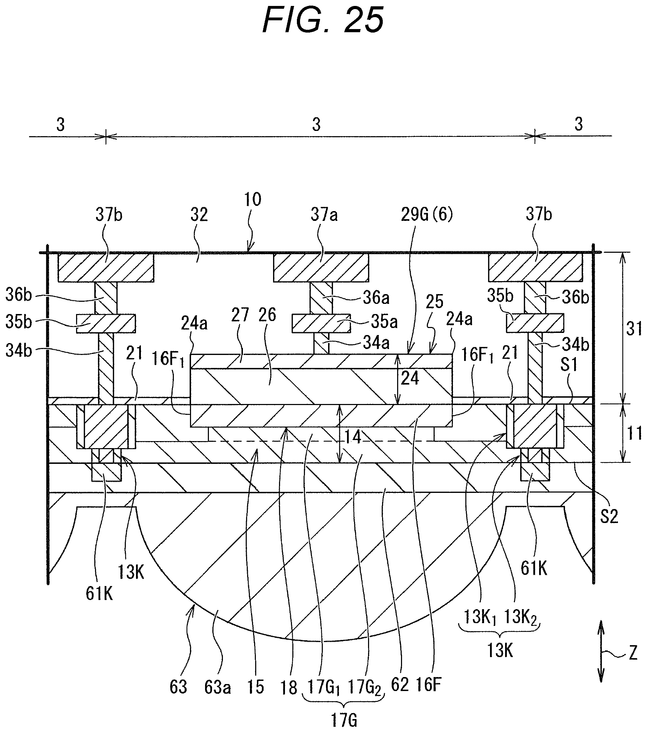

That is, as illustrated in Fig. 25, a pixel 3 of the seventeenth embodiment includes such separators 13K and 61K as described in the twelfth embodiment illustrated in Figs. 20A and 20B instead of the separator 13 and the light blocking film 61 of the eighth embodiment in Fig. 16. Other configurations are similar to those in the above eighth embodiment.

The distance image sensor according to the seventeenth embodiment can obtain effects similar to those of the distance image sensor according to the above eighth embodiment, and the opening area of a photoelectric converter 29G can be increased. As a result, the quantum efficiency (light receiving sensitivity) of the photoelectric converter 29G can be improved.

### [Eighteenth Embodiment]

A distance image sensor according to an eighteenth embodiment of the present technology is basically similar in configuration to the distance image sensor according to the above seventh embodiment, but is different in configuration of a pixel.

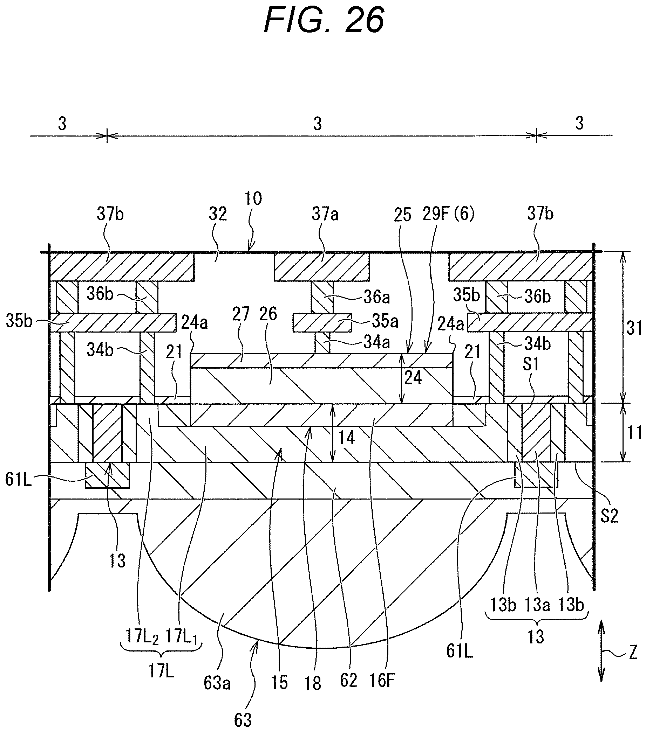

That is, as illustrated in Fig. 26, a pixel 3 of the eighteenth embodiment includes an n-type second semiconductor region 17L and a light blocking film 61L instead of the n-type second semiconductor region 17 and the light blocking film 61 of the seventh embodiment in Fig. 15. Further, the n-type second semiconductor region 17L and a contact electrode 34b are electrically connected in a different connection form. Other configurations are similar to those in the above seventh embodiment.

As illustrated in Fig. 26, the n-type second semiconductor region 17L of the eighteen embodiment is provided at a position deeper than the position of a p-type first semiconductor region 16F with respect to the side of a first face S1 of a first semiconductor portion 14, the n-type second semiconductor region 17L and the bottom of the p-type first semiconductor region 16F forms a pn junction 18, and the n-type second semiconductor region 17L includes a first portion 17L₁ having a contour in plan view located outside a contour of the p-type first semiconductor region 16F and a second portion 17L₂ protruding from the first portion 17L₁ toward the side of the first face S1 of the first semiconductor portion 14 along a separator 13. In addition, the contact electrode 34b penetrates a selection insulating film 21 and is electrically and mechanically connected to the second portion 17L₂. The second portion 17L₂ is disposed between the separator 13 and the p-type first semiconductor region 16F. Further, the p-type first semiconductor region 16F and the pn junction 18 are spaced apart from the second portion 17L₂. That is, the p-type first semiconductor region 16F is spaced apart from the connection portion between the second portion 17L₂ of the n-type second semiconductor region 17L and the contact electrode 34b.

Note that although not illustrated, a contact region including an n-type semiconductor region higher in impurity concentration than the n-type second semiconductor region 17L is provided in the second portion 17L₂ of the n-type second semiconductor region 17L, for the purpose of reducing ohmic resistance with the contact electrode.

The light blocking film 61L is narrower in width than the separator 13, similarly to the above light blocking film 61a. Further, the light blocking film 61L is electrically separated from the n-type second semiconductor region 17L. That is, the light blocking film 61L has a light blocking function, but does not have a function as a relay electrode unlike the light blocking film 61.

The distance image sensor according to the eighteenth embodiment can obtain effects similar to those of the distance image sensor 1 according to the above first embodiment. Further, the p-type first semiconductor region 16F is spaced apart from the connection portion between the n-type second semiconductor region 17L and the contact electrode 34b, and thus avalanche multiplication at the edge portion of the p-type first semiconductor region 16F can be suppressed.

### [Nineteenth Embodiment]

A distance image sensor according to a nineteenth embodiment of the present technology is basically similar in configuration to the distance image sensor according to the above eighteenth embodiment, but is different in configuration of a pixel.

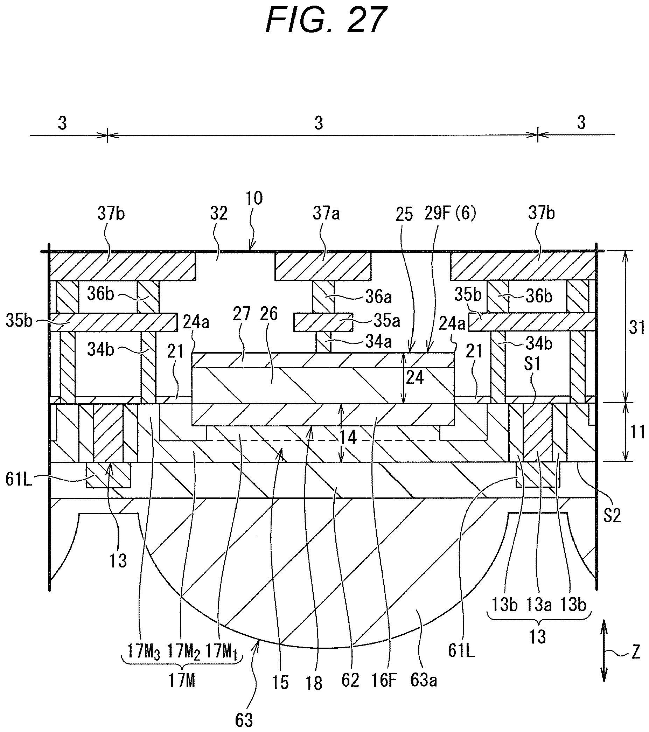

That is, as illustrated in Fig. 27, a pixel 3 of the eighteenth embodiment includes an n-type second semiconductor region 17M instead of the n-type second semiconductor region 17L of the eighteenth embodiment in Fig. 26. Other configurations are similar to those in the above eighteenth embodiment.

As illustrated in Fig. 27, the n-type second semiconductor region 17M of the nineteenth embodiment is provided at a position deeper than the position of a p-type first semiconductor region 16F with respect to the side of a first face S1 of a first semiconductor portion 14, the n-type second semiconductor region 17M and the bottom of the p-type first semiconductor region 16F forms a pn junction 18, and the n-type second semiconductor region 17M includes a first portion 17M₁ having a contour in plan view located inside a contour of the p-type first semiconductor region 16F. In addition, the n-type second semiconductor region 17M includes a second portion 17M₂ provided at a position deeper than the position the first portion 17M₁ with respect to the side of the first face S1 of the first semiconductor portion 14, and has a contour in plan view located outside a contour of the p-type first semiconductor region 16F in plan view, and a third portion 17M₃ protruding from the second portion 17M₂ toward the side of the first face S1 of the first semiconductor portion 14 along a separator 13. Further, a contact electrode 34b penetrates a selection insulating film 21 and is electrically and mechanically connected to the third portion 17M₃. The third portion 17M₃ is disposed between the separator 13 and the p-type first semiconductor region 16F. Furthermore, the p-type first semiconductor region 16F and the pn junction 18 are spaced apart from the third portion 17M₃. That is, the p-type first semiconductor region 16F is spaced apart from the connection portion between the third portion 17M₃ of the n-type second semiconductor region 17M and the contact electrode 34b. Still furthermore, the first portion 17M₁ having a contour located inside the contour of the p-type first semiconductor region 16F, and thus the pn junction 18 is located inside the contour of the p-type first semiconductor region 16F.

Note that although not illustrated, a contact region including a semiconductor region higher in impurity concentration than the n-type second semiconductor region 17M is provided in the third portion 17M₃ of the n-type second semiconductor region 17M, for the purpose of reducing ohmic resistance with the contact electrode.

The distance image sensor according to the nineteenth embodiment can obtain effects similar to those of the distance image sensor according to the above twelfth embodiment. Further, the pn junction 18 is located inside the contour of the p-type first semiconductor region 16F. Thus, a high electric field at the edge portion (contour 16F₁) of the p-type first semiconductor region 16F is avoidable. With this arrangement, avalanche multiplication biased to the edge portion of the p-type first semiconductor region 16F can be suppressed and avalanche multiplication can be made uniform over the entire pn junction 18, so that the light detection efficiency can be enhanced.

### [Twentieth Embodiment]

In the above first to nineteenth embodiments, the case where the first semiconductor region (16, 16F, or 16H) and the extrinsic semiconductor layer 27 each include a p-type semiconductor and the n-type second semiconductor region (17, 17G, 17L, or 17M) includes an n-type semiconductor has been described. The present technology, however, is applicable to a configuration in which a p-type semiconductor and an n-type semiconductor are interchanged. In the case of interchange, holes are detected, and a positive voltage is applied to an anode to operate.

Note that the avalanche photodiode (APD) elements described in the above first to twentieth embodiments each include a Geiger mode in which the APD element is operated at a bias voltage higher than the breakdown voltage and a linear mode in which the APD element is operated at a slightly higher bias voltage near the breakdown voltage. The Geiger-mode APD element is also called a single photon avalanche diode (SPAD) element.

### [Configuration of Electronic Apparatus]

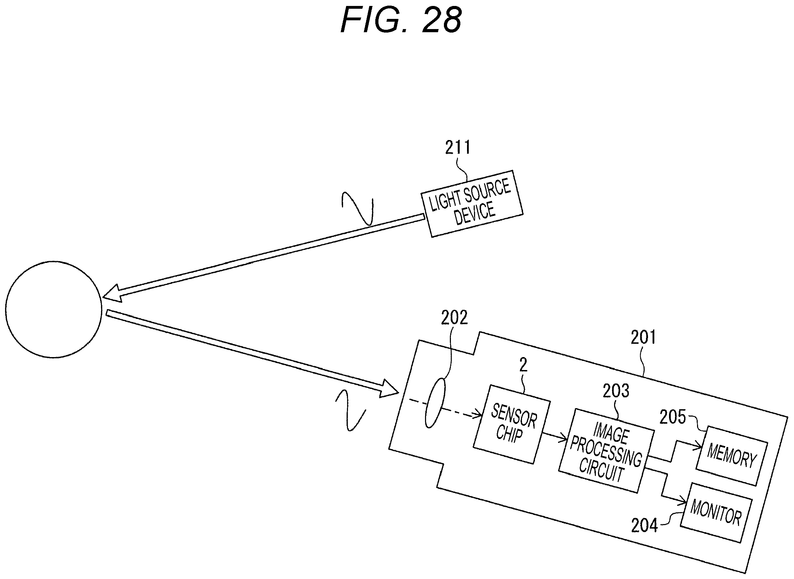

As illustrated in Fig. 28, a distance image apparatus 201 as an electronic apparatus includes an optical system 202, a sensor chip 2, an image processing circuit 203, a monitor 204, and a memory 205. The distance image apparatus 201 can acquire a distance image according to the distance to a subject by receiving light (modulated light or pulsed light) projected from a light source device 211 toward the subject and reflected from the surface of the subject.

The optical system 201 includes one or a plurality of lenses, guides image light (incident light) from the subject to the sensor chip 2, and forms an image on a light-receiving face (sensor unit) of the sensor chip 2.

As the sensor chip 2, the sensor chip 2 (10) with the distance image sensor of any of the above embodiments mounted thereon is applied, and a distance signal indicating a distance obtained from a light reception signal (APD OUT) output from the sensor chip 2 is supplied to the image processing circuit 203.

The image processing circuit 203 performs image processing of constructing a distance image on the basis of the distance signal supplied from the sensor chip 2. The distance image (image data) obtained by the image processing is supplied to and displayed on the monitor 204, or supplied to and stored (recorded) in the memory 205.

In the distance image apparatus 200 having such a configuration, by application of the above sensor chip 2, a distance to the subject can be calculated on the basis of only the light reception signal from a pixel 3 high in stability and a distance image high in accuracy. That is, the distance image apparatus 200 can acquire a more accurate distance image.

### [Examples of Use of Image Sensor]

The above sensor chip 2 (image sensor) can be used, for example, in various cases of sensing light such as visible light, infrared light, ultraviolet light, or X-rays as described below.
· Devices for shooting an image to be provided for viewing, such as digital cameras and portable devices with a camera function
· Devices to be provided for traffic, such as: on-board vehicle sensors for shooting the front, rear, surrounding, or inside of an automobile for safe driving such as automatic stop and for recognition of a driver's state or the like; surveillance cameras for surveilling traveling vehicles and roads; and distance sensors for measuring the distance between vehicles
· Devices to be provided for household electric appliances such as TVs, refrigerators, and air conditioners, in order to shoot a user's gesture and operate such an appliance in response to the gesture
· Devices to be provided for medical care and health care, such as endoscopes and devices for angiography by receiving infrared light
· Devices to be provided for security, such as surveillance cameras for crime prevention applications and cameras for person authentication applications
· Devices to be provided for beauty care, such as skin measuring instruments for shooting a skin and microscopes for shooting a scalp
· Devices to be provided for sports, such as action cameras and wearable cameras for sports applications or the like
· Devices to be provided for agriculture, such as cameras for monitoring the state of fields and crops

Note that the present technology can also adopt the following configurations.
(1) A photodetector including:
   a pixel region in which a plurality of pixels each having a photoelectric converter is arranged in a matrix,
   in which the photoelectric converter includes:
      a first semiconductor portion segmented by a separator;
      a second semiconductor portion provided on a side of a first face of the first semiconductor portion, the first face being opposite to a second face of the first semiconductor portion, the second semiconductor portion containing germanium;
      a light absorber with which the second semiconductor portion is provided, the light absorber being configured to absorb light having entered the second semiconductor portion to generate a carrier; and
      a multiplier with which the first semiconductor portion is provided, the multiplier being configured to avalanche-multiply the carrier generated by the light absorber.
(2) The photodetector according to (1) described above, in which the second semiconductor portion is narrower in band gap than the first semiconductor portion.
(3) The photodetector according to (1) or (2) described above, in which the second semiconductor portion is covalently bonded with the first semiconductor portion.
(4) The photodetector according to any of (1) to (3) described above, in which the first semiconductor portion contains silicon.
(5) The photodetector according to any of (1) to (4) described above, in which the second semiconductor portion has a contour located inside a contour of the first semiconductor portion in plan view.
(6) The photodetector according to any of (1) to (5) described above, in which the multiplier includes: a first semiconductor region of a first conductivity type, the first semiconductor region being provided on the side of the first face of the first semiconductor portion; and
   a second semiconductor region of a second conductivity type, the second semiconductor region being provided at a position deeper than a position of the first semiconductor region with respect to the side of the first face of the first semiconductor portion, the second semiconductor region and the first semiconductor region forming a pn junction in which an avalanche multiplication region is formed.
(7) The photodetector according to (6) described above, in which the second semiconductor portion includes either: a semiconductor layer of a conductivity type identical to the conductivity type of the first semiconductor region, the semiconductor layer containing germanium; or
   an extrinsic semiconductor layer of a conductivity type identical to the conductivity type of the first semiconductor region, the extrinsic semiconductor layer containing a compound of silicon and germanium.
(8) The photodetector according to (6) described above, in which the second semiconductor portion includes:
   a composite layer including, in order from a side closer to the first semiconductor portion, an intrinsic semiconductor layer containing a compound of silicon and germanium, and an extrinsic semiconductor layer of a conductivity type identical to the conductivity type of the first semiconductor region, the extrinsic semiconductor layer containing a compound of silicon and germanium; or

   a composite layer including, in order from the side closer to the first semiconductor portion, an intrinsic semiconductor layer containing germanium, and an extrinsic semiconductor layer of a conductivity type identical to the conductivity type of the first semiconductor layer, the extrinsic semiconductor layer containing germanium.
(9) The photodetector according to any of (1) to (8) described above, further including:
   a selection insulating film with which the second semiconductor portion is selectively formed on the side of the first face of the first semiconductor portion,
   in which the second semiconductor portion is selectively formed due to self-alignment to the selective insulating film.
(10) The photodetector according to (9) described above, in which the selection insulating film corresponds to a surface-type insulating film covering the side of the first face of the first semiconductor portion or an embedded-type insulating film embedded in the first semiconductor portion so as to be exposed from the first face.
(11) The photodetector according to any of (1) to (10) described above, in which
   the separator includes a separation conductor extending in a thickness direction of the first semiconductor portion, and a separation insulator covering each of a side face on either side of the separating conductor, and
   the second semiconductor region is electrically connected to the separation conductor.
(12) The photodetector according to (11) described above, in which the second semiconductor region is electrically connected to the separation conductor through a relay electrode provided on a side of the second face of the first semiconductor portion.
(13) The photodetector according to (11) described above, in which the second semiconductor region is connected to the separation conductor closer to the first face of the first semiconductor portion than the second face of the first semiconductor portion.
(14) The photodetector according to any of (1) to (13) described above, further including:
   a first metal wired line provided in superposition on the second semiconductor portion in plan view on a side opposite to a side closer to the first semiconductor portion of the second semiconductor portion, the first metal wired line having a contour located outside a contour of the second semiconductor portion.
(15) The photodetector according to any of (1) to (14) described above, in which the first semiconductor portion includes a light reflector uneven in shape on a side of the second face.
(16) The photodetector according to any of (1) to (15) described above, in which the second semiconductor portion has an upper face and a side face, and
   the side face inclines such that an interior angle between the upper face and the side face is obtuse.
(17) The photodetector according to any of (1) to (16) described above,
   in which
   the first semiconductor portion includes a groove extending from the side of the first face to a side of the second face,
   the first semiconductor region and the second semiconductor region are provided in superimposition on the groove, the first semiconductor region and the second semiconductor region being closer to the side of the second face than the groove is, and
   the second semiconductor portion is provided in the groove.
(18) The photodetector according to (9) described above, further including: a peripheral region disposed outside the pixel region; and
   a peripheral semiconductor portion formed in the peripheral region so as to be identical in layer to the first semiconductor portion, the peripheral semiconductor portion being covered with the selection insulating film.
(19) The photodetector according to (6) described above, in which the first semiconductor region is spaced apart from the separator.
(20) The photodetector according to claim 19, in which the second semiconductor region has a portion forming the pn junction with the first semiconductor region, the portion being located inside a contour of the first semiconductor region in plan view.
(21) The photodetector according to any of (1) to (20) described above, further including: a microlens layer provided on a side of the second face of the first semiconductor portion.
(22) An electronic apparatus, including:
   a photodetector including
   a semiconductor layer including a first semiconductor portion segmented by a separator,
   a multiplier including a pn junction in which an avalanche multiplication region is formed, and
   a second semiconductor portion provided on a side of a first face of the first semiconductor portion, the first face being opposite to a second face of the first semiconductor portion, the second semiconductor portion containing germanium; and
   an optical system configured to form an image onto the first face of the first semiconductor portion, with image light from a subject.

The scope of the present technology is not limited to the illustrated and described exemplary embodiments, but also includes all embodiments that provide equivalent effects to those for which the present technology is intended. Furthermore, the scope of the present technology is not limited to the combinations of the features of the invention defined by the claims, but may be defined by any desired combination of specific features among all the disclosed features.

### REFERENCE SIGNS LIST

1 Distance image sensor (photodetector)
2 Sensor chip
2A Pixel region
2B Peripheral region
3 Pixel
4 Electrode pad
5 Bias-voltage applying unit
6 APD element (avalanche photodiode element)
7 Quenching resistive element
8 Inverter
10 First semiconductor base (sensor-side semiconductor base)
11 Semiconductor layer
13, 13K Separator
13a Separation conductor
13b Separation insulator
14 First semiconductor portion
14E Groove
15 Multiplier
16, 16F, 16H P-type first semiconductor region
17, 17G, 17L, 17M N-type second semiconductor region
18 Pn junction
19 Peripheral semiconductor portion
19a First peripheral region
19b Second peripheral region
20 Separator
21 Surface-type selection insulating film
22 Embedded-type selection insulating film
24, 24D Second semiconductor portion
25 Light absorber
26 Intrinsic semiconductor layer (i-SiGe)
27 P-type extrinsic semiconductor layer (p-SiGe)
29, 29C, 29D, 29E, 29G, 29H, 29J Photoelectric converter
31 Multi-level wiring layer (sensor-side multi-level wiring layer)
32 Interlayer insulating film
34a, 34b Contact electrode
35a, 35B First metal wired line
35b Second metal wired line
36a, 36b Contact electrode
37a, 37b Metal pad
40 Second semiconductor base (logic-side semiconductor base)
41 Semiconductor substrate
42 Gate electrode
51 Multi-level wiring layer (logic-side multi-level wiring layer)
52 Interlayer insulating film
53 Wired line
55a, 55b Electrode pad
56a, 56b Contact electrode
57a, 57b Metal pad
61, 61K Light blocking film (relay electrode)
61a Light blocking film
62 Planarization film
63 Microlens layer
63a Microlens unit
63b Flat portion

## Claims

1. A photodetector comprising:
a pixel region in which a plurality of pixels each having a photoelectric converter is arranged in a matrix,
wherein the photoelectric converter includes:
a first semiconductor portion segmented by a separator;
a second semiconductor portion provided on a side of a first face of the first semiconductor portion, the first face being opposite to a second face of the first semiconductor portion, the second semiconductor portion containing germanium;
a light absorber with which the second semiconductor portion is provided, the light absorber being configured to absorb light having entered the second semiconductor portion to generate a carrier; and
a multiplier with which the first semiconductor portion is provided, the multiplier being configured to avalanche-multiply the carrier generated by the light absorber.

2. The photodetector according to claim 1, wherein the second semiconductor portion is narrower in band gap than the first semiconductor portion.

3. The photodetector according to claim 1, wherein the second semiconductor portion is covalently bonded with the first semiconductor portion.

4. The photodetector according to claim 1, wherein the first semiconductor portion contains silicon.

5. The photodetector according to claim 1, wherein the second semiconductor portion has a contour located inside a contour of the first semiconductor portion in plan view.

6. The photodetector according to claim 1, wherein the multiplier includes:
a first semiconductor region of a first conductivity type, the first semiconductor region being provided on the side of the first face of the first semiconductor portion; and
a second semiconductor region of a second conductivity type, the second semiconductor region being provided at a position deeper than a position of the first semiconductor region with respect to the side of the first face of the first semiconductor portion, the second semiconductor region and the first semiconductor region forming a pn junction in which an avalanche multiplication region is formed.

7. The photodetector according to claim 6, wherein the second semiconductor portion includes either: a semiconductor layer of a conductivity type identical to the conductivity type of the first semiconductor region, the semiconductor layer containing germanium; or
an extrinsic semiconductor layer of a conductivity type identical to the conductivity type of the first semiconductor region, the extrinsic semiconductor layer containing a compound of silicon and germanium.

8. The photodetector according to claim 6, wherein the second semiconductor portion includes:
a composite layer including, in order from a side closer to the first semiconductor portion, an intrinsic semiconductor layer containing a compound of silicon and germanium, and an extrinsic semiconductor layer of a conductivity type identical to the conductivity type of the first semiconductor region, the extrinsic semiconductor layer containing a compound of silicon and germanium; or
a composite layer including, in order from the side closer to the first semiconductor portion, an intrinsic semiconductor layer containing germanium, and an extrinsic semiconductor layer of a conductivity type identical to the conductivity type of the first semiconductor layer, the extrinsic semiconductor layer containing germanium.

9. The photodetector according to claim 1, further comprising:
a selection insulating film with which the second semiconductor portion is selectively formed on the side of the first face of the first semiconductor portion,
wherein the second semiconductor portion is selectively formed due to self-alignment to the selective insulating film.

10. The photodetector according to claim 9, wherein the selection insulating film corresponds to a surface-type insulating film covering the side of the first face of the first semiconductor portion or an embedded-type insulating film embedded in the first semiconductor portion so as to be exposed from the first face.

11. The photodetector according to claim 1, wherein
the separator includes a separation conductor extending in a thickness direction of the first semiconductor portion, and a separation insulator covering each of a side face on either side of the separating conductor, and
the second semiconductor region is electrically connected to the separation conductor.

12. The photodetector according to claim 11, wherein the second semiconductor region is electrically connected to the separation conductor through a relay electrode provided on a side of the second face of the first semiconductor portion.

13. The photodetector according to claim 11, wherein the second semiconductor region is connected to the separation conductor closer to the first face of the first semiconductor portion than the second face of the first semiconductor portion.

14. The photodetector according to claim 1, further comprising:
a first metal wired line provided in superposition on the second semiconductor portion in plan view on a side opposite to a side closer to the first semiconductor portion of the second semiconductor portion, the first metal wired line having a contour located outside a contour of the second semiconductor portion.

15. The photodetector according to claim 1, wherein the first semiconductor portion includes a light reflector uneven in shape on a side of the second face.

16. The photodetector according to claim 1, wherein the second semiconductor portion has an upper face and a side face, and
the side face inclines such that an interior angle between the upper face and the side face is obtuse.

17. The photodetector according to claim 1, wherein
the first semiconductor portion includes a groove extending from the side of the first face to a side of the second face,
the first semiconductor region and the second semiconductor region are provided in superimposition on the groove, the first semiconductor region and the second semiconductor region being closer to the side of the second face than the groove is, and
the second semiconductor portion is provided in the groove.

18. The photodetector according to claim 9, further comprising: a peripheral region disposed outside the pixel region; and
a peripheral semiconductor portion formed in the peripheral region so as to be identical in layer to the first semiconductor portion, the peripheral semiconductor portion being covered with the selection insulating film.

19. The photodetector according to claim 6, wherein the first semiconductor region is spaced apart from the separator.

20. The photodetector according to claim 19, wherein the second semiconductor region has a portion forming the pn junction with the first semiconductor region, the portion being located inside a contour of the first semiconductor region in plan view.

21. The photodetector according to claim 1, further comprising: a microlens layer provided on a side of the second face of the first semiconductor portion.

22. An electronic apparatus, comprising:
a photodetector including
a semiconductor layer including a first semiconductor portion segmented by a separator,
a multiplier including a pn junction in which an avalanche multiplication region is formed, and
a second semiconductor portion provided on a side of a first face of the first semiconductor portion, the first face being opposite to a second face of the first semiconductor portion, the second semiconductor portion containing germanium; and
an optical system configured to form an image onto the first face of the first semiconductor portion, with image light from a subject.
